# EUROPEAN PATENT SPECIFICATION

(11) **EP 4 376 081 B1**
(45) Date of publication and mention of the grant of the patent: **20.05.2026**
(21) Application number: 23207703.2
(22) Date of filing: 03.11.2023
(51) Int. Cl.: H10D 86/40, H10K 59/124, H10K 59/131, H10D 86/60

(54) **DISPLAY DEVICE**
ANZEIGEVORRICHTUNG
DISPOSITIF D'AFFICHAGE

(30) Priority: 08.11.2022 KR 20220148134
(43) Date of publication of application: 29.05.2024
(73) Proprietor: Samsung Display Co., Ltd., Yongin-si, Gyeonggi-do 17113 (KR)
(72) Inventor: Park, Kwangwoo, 17113 Giheung-gu, Yongin-si, Gyeonggi-do (KR); Shim, Donghwan, 17113 Giheung-gu, Yongin-si, Gyeonggi-do (KR); Lee, Eonjoo, 17113 Giheung-gu, Yongin-si, Gyeonggi-do (KR); Lee, Jinyong, 17113 Giheung-gu, Yongin-si, Gyeonggi-do (KR); Jang, Cheol, 17113 Giheung-gu, Yongin-si, Gyeonggi-do (KR); Jo, Yongseon, 17113 Giheung-gu, Yongin-si, Gyeonggi-do (KR)
(74) Representative: Dr. Weitzel & Partner

(56) References cited:
- US-A1- 2016 118 451
- US-A1- 2017 294 450
- US-A1- 2019 148 476
- US-A1- 2021 249 449

## Description

### BACKGROUND

### 1. Field

The present invention relates to a display device.

### 2. Description of the Related Art

In display devices that include light emitting diodes, thin film transistors are arranged in a display area to control luminance of each of the light emitting diodes. The thin film transistors control a light emitting diode to emit light having a certain color by using a data signal, a driving voltage, and a common voltage.

US2017/294450 A1 discloses a display device having a groove formed in an inorganic insulating layer disposed between pixels.

### SUMMARY

The present invention is defined by independent claim 1. Preferred embodiments are defined in the dependent claims. The present invention relates to a display device in which a display quality may be maintained even with respect to an external impact.

Additional aspects will be set forth in part in the description which follows and, in part, will be apparent from the description, or may be learned by practice of the presented embodiments of the invention.

The display device according to the invention includes a substrate, a scan line disposed on the substrate and extending in a first direction, a data line disposed on the substrate and extending in a second direction crossing the first direction, a first transistor disposed on the substrate and including a first semiconductor layer and a first gate electrode overlapping the first semiconductor layer, a second transistor including a second semiconductor layer electrically connected to the first transistor and the data line and a second gate electrode overlapping the second semiconductor layer and electrically connected to the scan line, at least one inorganic insulating layer disposed on the substrate, an auxiliary transistor disposed at an opposite side to the second transistor with a valley defined in the at least one inorganic insulating layer therebetween, wherein the auxiliary transistor is electrically connected to the data line and the scan line.

The auxiliary transistor may include an auxiliary semiconductor layer disposed at an opposite side to the second semiconductor layer with the valley therebetween, and an auxiliary gate electrode electrically connected to the scan line and overlapping the auxiliary semiconductor layer.

The display device may further include a first connection line configured to electrically connect the data line and the auxiliary semiconductor layer to each other, the first connection line overlapping the valley, and a second connection line configured to electrically connect the auxiliary semiconductor layer and the first semiconductor layer to each other, the second connection line overlapping the valley.

The first connection line and the second connection line may have the same material.

The first connection line and the second connection line may have the same material as the scan line.

The display device may further include a first auxiliary scan line including the second gate electrode, and a second auxiliary scan line including the auxiliary gate electrode, and each of the first auxiliary scan line and the second auxiliary scan line may be electrically connected to the scan line.

The first auxiliary scan line and the second auxiliary scan line may be spaced apart from each other with the valley therebetween.

The auxiliary semiconductor layer may include the same material as the second semiconductor layer.

The display device may further include an organic insulating material at least partially filling the valley.

According to another aspect, the present invention discloses a display device including a first sub-pixel circuit area and a second sub-pixel circuit area arranged adjacent to each other, a scan line extending in a first direction and passing through the first sub-pixel circuit area and the second sub-pixel circuit area, a data line extending in a second direction crossing the first direction and passing through the first sub-pixel circuit area, a first transistor including a first semiconductor layer disposed in the first sub-pixel circuit area and a first gate electrode overlapping the first semiconductor layer, a second transistor including a second semiconductor layer electrically connected to the first transistor and the data line and disposed in the first sub-pixel circuit area and a second gate electrode overlapping the second semiconductor layer and electrically connected to the scan line, a valley located between the first sub-pixel circuit area and the second sub-pixel circuit area and defined in at least one inorganic insulating layer, and an auxiliary transistor including an auxiliary semiconductor layer disposed in the second sub-pixel circuit area and an auxiliary gate electrode overlapping the auxiliary semiconductor layer, wherein the auxiliary transistor is electrically connected to the data line and the scan line.

The display device may further include a first connection line configured to electrically connect the data line and the auxiliary semiconductor layer to each other, the first connection line overlapping the valley, and a second connection line configured to electrically connect the auxiliary semiconductor layer and the first semiconductor layer to each other, the second connection line overlapping the valley.

The first connection line and the second connection line may have the same material.

The display device may further include a first auxiliary scan line including the second gate electrode and a second auxiliary scan line including the auxiliary gate electrode, and each of the first auxiliary scan line and the second auxiliary scan line may be electrically connected to the scan line.

The first auxiliary scan line and the second auxiliary scan line may be spaced apart from each other with the valley therebetween.

The display device may further include an organic insulating material at least partially filling the valley.

The auxiliary semiconductor layer may include the same material as the second semiconductor layer.

The display device may further include a first connection line disposed on the organic insulating material and configured to electrically connect the data line and the auxiliary semiconductor layer to each other, the first connection line overlapping the valley, and a second connection line disposed on the organic insulating material and configured to electrically connect the auxiliary semiconductor layer and the first semiconductor layer to each other, the second connection line overlapping the valley.

The display device may further include a third transistor disposed in the first sub-pixel circuit area and electrically connected to the first transistor.

The third transistor may include a third semiconductor layer including a different material from the first semiconductor layer, and a third gate electrode overlapping the third semiconductor layer.

The first semiconductor layer and the third semiconductor layer may be arranged on different layers.

### BRIEF DESCRIPTION OF THE DRAWINGS

The above and other aspects, features, and advantages of certain embodiments of the invention will be more apparent from the following description taken in conjunction with the accompanying drawings, in which:
FIG. 1 is a plan view schematically illustrating a display device according to an embodiment;
FIG. 2 is an equivalent circuit diagram schematically illustrating any one light emitting diode and a sub-pixel circuit connected to the light emitting diode of a display device according to an embodiment;
FIG. 3 is a plan view schematically illustrating a portion of a display area of the display device according to an embodiment;
FIG. 4 is a cross-sectional view of the display device taken along a line A-A' and a line B-B' of FIG. 3;
FIG. 5 illustrates a modified embodiment of the display device taken along a line B-B' of FIG. 3;
FIGS. 6, 7, 8, 9, 10, 11, 12, 13, and 14 are plan views of components arranged in the display area of the display device of FIG. 1, according to processes of forming the components;
FIG. 15 is an extracted plan view illustrating a portion of a first transistor and a second transistor arranged in a first sub-pixel circuit area of the display device shown in FIG. 14 and an auxiliary transistor arranged in a second sub-pixel circuit area of the display device of FIG. 14; and
FIG. 16 is an extracted plan view illustrating a portion of the first transistor and the second transistor arranged in the second sub-pixel circuit area of the display device shown in FIG. 14 and the auxiliary transistor arranged in the first sub-pixel circuit area of the display device of FIG. 14.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description.

As used herein, the word "or" means logical "or" so that, unless the context indicates otherwise, the expression "A, B, or C" means "A and B and C," "A and B but not C," "A and C but not B," "B and C but not A," "A but not B and not C," "B but not A and not C," and "C but not A and not B." Throughout the invention, the expression "at least one of a, b and c" indicates only a, only b, only c, both a and b, both a and c, both b and c, all of a, b, and c, or variations thereof.

Since various modifications and various embodiments of the present invention are possible, specific embodiments are illustrated in the drawings and described in detail in the detailed description. Effects and features of the present invention, and a method of achieving them will be apparent with reference to embodiments described below in detail in conjunction with the drawings. However, the present invention is not limited to the embodiments disclosed herein, but may be implemented in a variety of forms.

Hereinafter, embodiments of the present invention will be described in detail with reference to the accompanying drawings, and the same or corresponding components are denoted by the same reference numerals, and the same reference numerals are assigned and redundant explanations will be omitted.

In the following embodiment, when a component such as a layer, a film, a region, a plate or the like is "on" other components, this is not only when the component is "directly on" other components, but also when other components are interposed therebetween. In the drawings, for convenience of description, the sizes of components may be exaggerated or reduced. For example, since the size and thickness of each component shown in the drawings are arbitrarily indicated for convenience of description, the present invention is not necessarily limited to the illustration.

In the following embodiment, the x-axis, y-axis, and z-axis are not limited to three axes on an orthogonal coordinate system, and may be interpreted in a broad sense including this case. For example, the x-axis, the y-axis, and the z-axis may be orthogonal to each other, but may refer to different directions that are not orthogonal to each other.

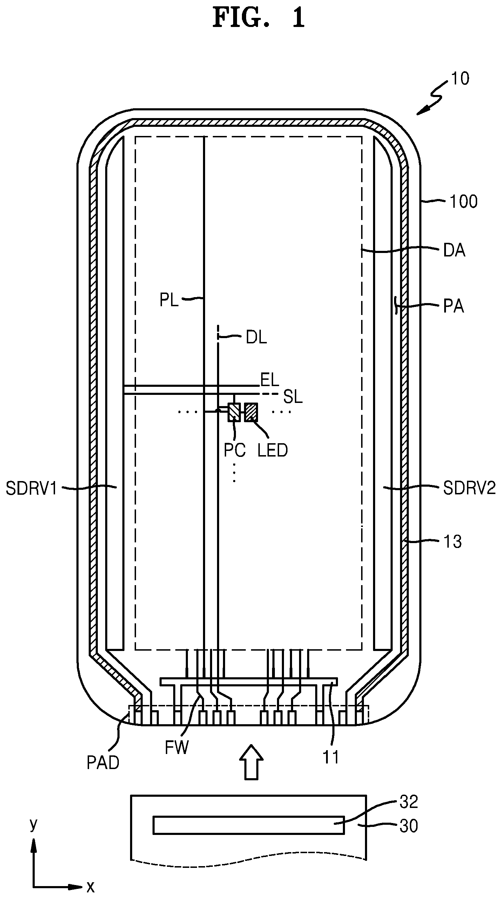

FIG. 1 is a plan view schematically illustrating a display device according to an embodiment.

Referring to FIG. 1, various components that constitute a display device 10 may be arranged on a substrate 100. The substrate 100 may include a display area DA and a peripheral area PA surrounding the display area DA. The display area DA may be covered by a sealing member and may be protected from outside air, moisture, or the like.

Light emitting diodes (LEDs) may be arranged in the display area DA of the substrate 100. The display device 10 may display an image by light emitted from the LEDs. LEDs may emit red, green, or blue light, for example.

Each LED may be electrically connected to a sub-pixel circuit PC, and each sub-pixel circuit PC may include transistors and a storage capacitor. Each of the sub-pixel circuits PC may be electrically connected to peripheral circuits arranged in the peripheral area PA. The peripheral circuits arranged in the peripheral area PA may include a first scan driving circuit SDRV1, a second scan driving circuit SDRV2, a terminal portion PAD, a driving voltage supply line 11, and common voltage supply lines 13.

The first scan driving circuit SDRV1 may apply a scan signal to each of the sub-pixel circuits PC through a scan line SL. The scan line SL may be also called as a first scan line SL1, a second scan line SL2, a third scan line SL3 and a fourth scan line SL4. The first scan driving circuit SDRV1 may apply an emission control signal to each sub-pixel circuit PC through an emission control line EL. The second scan driving circuit SDRV2 may be positioned at an opposite side to the first scan driving circuit SDRV1 centered on the display area DA. A portion of the sub-pixel circuits PC may be electrically connected to the first scan driving circuit SDRV1, and the other portion of the sub-pixel circuits PC may be electrically connected to the second scan driving circuit SDRV2. In some embodiments, the second scan driving circuit SDRV2 may be omitted.

The terminal portion PAD may be disposed at one side of the substrate 100. The terminal portion PAD may not be covered by an insulating layer but may be exposed and may be connected to a display circuit board 30. A display driving portion 32 may be disposed on the display circuit board 30.

The display driving portion 32 may generate a control signal to be transmitted to the first scan driving circuit SDRV1 and the second scan driving circuit SDRV2. The display driving portion 32 may generate a data signal, and the generated data signal may be transmitted to the sub-pixel circuit PC through a fan-out wiring FW and a data line DL connected to the fan-out wiring FW.

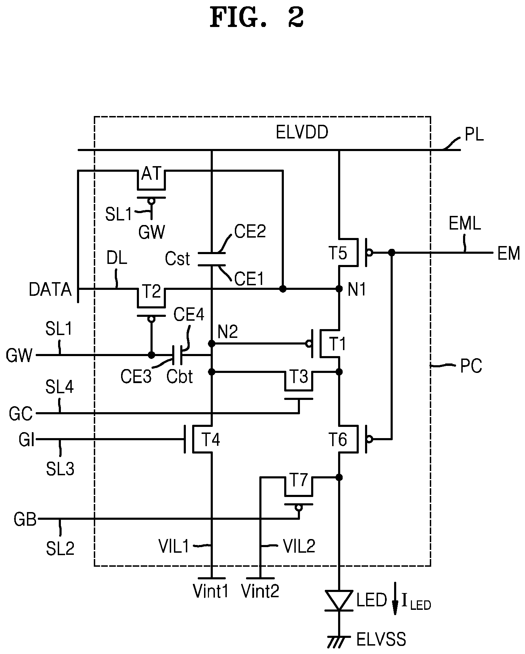

The display driving portion 32 may supply a driving voltage (or first power supply voltage) ELVDD (see FIG. 2) to the driving voltage supply line 11 and may supply a common voltage (or second power supply voltage) ELVSS (see FIG. 2) to the common voltage supply line 13. The driving voltage ELVDD may be applied to the sub-pixel circuit PC through the driving voltage line PL connected to the driving voltage supply line 11, and the common voltage ELVSS may be applied to a second electrode (e.g., a cathode) of each LED through the common voltage supply line 13.

The driving voltage supply line 11 may extend in an x-direction from a lower side of the display area DA. The common voltage supply line 13 may have a loop shape of which one side is open, thereby partially surrounding the display area DA.

The display device 10 of FIG. 1 may be a device for displaying a moving picture or still image and may be a portable electronic device such as a mobile phone, a smartphone, a tablet personal computer (PC), a mobile communication terminal, an electronic notebook, an electronic book, a portable multimedia player (PMP), a navigation device, an ultra mobile PC (UMPC), or the like. Alternatively, the display device 10 may be used as a display screen of various products such as a television, a laptop computer, a monitor, an advertisement board, and the Internet of Things (IoT). In addition, the display device 1 according to an embodiment may be used for a wearable device, such as a smart watch, a watch phone, a glass type display, or a head mounted display (HMD). In addition, the display device 10 according to an embodiment may be used as an instrument panel of a vehicle, and a center information display (CID) disposed on a center fascia or a dashboard of a vehicle, a room mirror display for replacing a side mirror of a vehicle, and a display disposed on a rear surface of a front seat as an entertainment for a rear seat of the vehicle.

In an embodiment, the display device 10 may be a foldable display device. For example, the display device 10 may be folded centered on a folding axis extending in the first direction (e.g., an x-direction) or a second direction (e.g., a y-direction).

FIG. 2 is an equivalent circuit diagram schematically illustrating one light emitting diode and a sub-pixel circuit connected to the light emitting diode of a display device according to an embodiment.

Referring to FIG. 2, the LED may be electrically connected to the sub-pixel circuit PC including a plurality of transistors and a storage capacitor.

The LED may be an organic light emitting diode including an organic material as a light emitting material. In another embodiment, the LED may be an inorganic light emitting diode including an inorganic material. The inorganic light emitting diode may include a PN junction diode including inorganic semiconductor-based materials. When a voltage is applied to a PN junction diode in a forward direction, holes and electrons may be injected, and energy generated by recombination of the holes and electrons may be converted into light energy to emit light of a certain color.

The LED may be a micro scale or nano scale. For example, the LED may be a micro light emitting diode. Alternatively, the LED may be a nanorod light emitting diode. The nanorod light emitting diode may include gallium nitride (GaN).

In some embodiments, the LED may include a quantum dot light emitting diode. As described above, a light emitting layer of the LED may include an organic material, an inorganic material, a quantum dot, an organic material and a quantum dot, or an inorganic material and a quantum dot. Hereinafter, for convenience of explanation, the case where the LED includes an organic light emitting diode, will be described.

The sub-pixel circuit PC may include a first transistor T1, a second transistor T2, a third transistor T3, a fourth transistor T4, a fifth transistor T5, a sixth transistor T6, and a seventh transistor T7. The sub-pixel circuit PC may include an auxiliary transistor AT. The sub-pixel circuit PC may include a first capacitor Cst and a second capacitor Cbt.

The sub-pixel circuit PC may be connected to signal lines, first and second initialization voltage lines VIL1 and VIL2, and a driving voltage line PL. The signal lines may include a data line DL, a first scan line SL1, a second scan line SL2, a third scan line SL3, a fourth scan line SL4, and an emission control line EML (which may correspond to the emission control line EL described above with reference to FIG. 1). In another embodiment, at least one of the signal lines, for example, the first and second initialization voltage lines VIL1 and VIL2 or the driving voltage line PL may be shared in adjacent sub-pixel circuits PC.

The driving voltage line PL may be configured to transmit the first power supply voltage ELVDD to the first transistor T1. The first initialization voltage line VIL1 may be configured to transmit the first initialization voltage Vint1 for initializing the first transistor T1 to the sub-pixel circuit PC. The second initialization voltage line VIL2 may be configured to transmit the second initialization voltage Vint2 for initializing the LED to the sub-pixel circuit PC.

Source and drain electrodes of the first transistor T1 may be connected to the driving voltage line PL via the fifth transistor T5 and may be electrically connected to the LED via the sixth transistor T6, respectively. The first transistor T1 may serve as a driving transistor. A gate electrode of the first transistor T1 may receive a data signal DATA in response to a switching operation of the second transistor T2. The first transistor T1may supply a driving current I_{LED} to the LED.

The second transistor T2 may be a switching transistor. A gate electrode of the second transistor T2 may be connected to the first scan line SL1. Source and drain electrodes of the second transistor T2 may be connected to the data line DL and the driving voltage line PL via the fifth transistor T5, respectively. The second transistor T2 may be turned on in response to a first scan signal GW transmitted through the first scan line SL1 and may perform a switching operation of transmitting the data signal DATA transmitted from the data line DL to a node N1.

The third transistor T3 may be a compensation transistor. A gate electrode the third transistor T3 may be connected to the fourth scan line SL4. Source and drain electrodes of the third transistor T3 and may be connected to a node N2 and the LED via the sixth transistor T6, respectively. The third transistor T3 may be turned on in response to a fourth scan signal GC transmitted through the fourth scan line SL4 and may diode-connect the first transistor T1.

The fourth transistor T4 may be a first initialization transistor. A gate electrode of the fourth transistor T4 may be connected to a third scan line SL3, which is a previous scan line. Source and drain electrodes of the fourth transistor T4 may be connected to the first initialization voltage line VIL1 and the node N2, respectively. The fourth transistor T4 may be turned on in response to a third scan signal GI, which is a previous scan signal transmitted through the third scan line SL3. The fourth transistor T4 may transmit the first initialization voltage Vint1 from the first initialization voltage line VIL1 to a gate electrode of the first transistor T1 and may initialize a voltage of the gate electrode of the first transistor T1.

The fifth transistor T5 may be an operation control transistor, and the sixth transistor T6 may be an emission control transistor. Gate electrodes of the fifth transistor T5 and the sixth transistor T6 may be connected to the emission control line EML and may be simultaneously turned on in response to the emission control signal EM transmitted through the emission control line EML. Source and drain electrodes of the fifth and sixth transistors T5 and T6 may form a current path on which the driving current I_{LED} may flow in a direction to the LED from the driving voltage line PL.

The seventh transistor T7 may be a second initialization transistor. A gate electrode of the seventh transistor T7 may be connected to the second scan line SL2. Source and drain electrodes of the seventh transistor T7 are connected to the second initialization voltage line VIL2 and the sixth transistor T6, respectively. The seventh transistor T7 may be turned on in response to the second scan signal GB transmitted through the second scan line SL2 and may transmit a second initialization voltage Vint2 from the second initialization voltage line VIL2 to the LED to initialize the LED. The seventh transistor T7 may be omitted. The second scan signal GB of the second scan line SL2 may be a scan signal of a first scan line disposed in a previous row of the sub-pixel circuit PC.

The first capacitor Cst may include a first capacitor electrode CE1 and a second capacitor electrode CE2. The first capacitor electrode CE1 may be connected to a gate electrode of the first transistor T1, and the second capacitor electrode CE2 may be connected to the driving voltage line PL. The first capacitor Cst may be a storage capacitor and may store and maintain a voltage corresponding to a difference between voltage of the driving voltage line PL and voltage of the gate electrode of the first transistor T1, thereby maintaining a voltage applied to the gate electrode of the first transistor T1.

The second capacitor Cbt may include a third capacitor electrode CE3 and a fourth capacitor electrode CE4. The third capacitor electrode CE3 may be connected to the first scan line SL1 and a gate electrode of the second transistor T2. The fourth capacitor electrode CE4 may be connected to the gate electrode of the first transistor T1 and a first capacitor electrode CE1 of the first capacitor Cst. The second capacitor Cbt may be a boosting capacitor and may reduce a voltage (black voltage) for displaying black by increasing a voltage of the node N2 when the first scan signal GW of the first scan line SL1 is a voltage for turning on the second transistor T2.

The LED may include a first electrode (e.g., an anode) and a second electrode (e.g., a cathode) that face each other, and a light emitting layer between the first electrode and the second electrode. A second power supply voltage ELVSS may be applied to the second electrode. The light emitting layer of the LED may emit light by receiving the driving current ILED from the first transistor T1.

The auxiliary transistor AT may be an auxiliary switching transistor. A gate electrode of the auxiliary transistor AT may be connected to the first scan line SL1. Source and drain electrodes of the auxiliary transistor AT may be connected to the data line DL and the node N1, respectively. The auxiliary transistor AT may substantially perform an operation of the second transistor T2. For example, the auxiliary transistor AT may be turned on in response to the first scan signal GW transmitted through the first scan line SL1 and may perform a switching operation of transmitting the data signal DATA transmitted to the data line DL to the node N1. The auxiliary transistor AT may form a bypass path when a normal operation of the second transistor T2 becomes degraded due to an impact that may occur when an object such as a stylus pen drops to the display area.

A detailed operation of the sub-pixel circuit PC according to an embodiment will be described as below.

When a third scan signal GI is supplied through the third scan line SL3 during a first initialization period, the fourth transistor T4 may be turned on in response to the third scan signal GI, and the first transistor T1 may be initialized by the first initialization voltage Vint1 supplied from the first initialization voltage line VIL1.

When the first scan signal GW and the fourth scan signal GC are supplied through the first scan line SL1 and the fourth scan line SL4 respectively during a data programming period, the second transistor T2 and the third transistor T3 may be turned on in response to the first scan signal GW and the fourth scan signal GC respectively. When the second transistor T2 is turned on, the auxiliary transistor AT may also be turned on. The first transistor T1 may be diode-connected by the turned-on third transistor T3 and may be biased in a forward direction. Then, a voltage (i.e. a compensation voltage) in which a threshold voltage of the first transistor T1 is compensated from the data signal DATA supplied from the data line DL, may be applied to the gate electrode of the first transistor T1. The first power supply voltage ELVDD and the compensation voltage may be applied to both ends of the first capacitor Cst, and an electric charge corresponding to a both-end voltage difference may be stored in the first capacitor Cst.

During an emission period, the fifth transistor T5 and the sixth transistor T6 may be turned on by the emission control signal EM supplied from the emission control line EML. A driving current ILED according to a voltage difference between the voltage of the gate electrode of the first transistor T1 and the first power supply voltage ELVDD may be generated, and the driving current ILED may be supplied to the LED through the sixth transistor T6.

When a second scan signal GB is supplied through the second scan line SL2 during a second initialization period, the seventh transistor T7 may be turned on in response to the second scan signal GB, and the LED may be initialized by the second initialization voltage Vint2 supplied from the second initialization voltage line VIL2.

At least one of the first through seventh transistors T1 to T7 of the sub-pixel circuit PC may include a semiconductor layer including an oxide, and the other of the first through seventh transistors T1 to T7 of the sub-pixel circuit PC may include a semiconductor layer including silicon. FIG. 2 illustrates that the third transistor T3 and the fourth transistor T4 may be implemented with n-channel metal oxide semiconductor field effect transistors (MOSFETs) (NMOSs) that are oxide-based transistors and the first transistor T1, the second transistor T2, the auxiliary transistor AT, the fifth transistor T5, the sixth transistor T6 and the seventh transistor T7 are implemented with p-channel MOSFETs (PMOSs) that are silicon-based transistors. In another embodiment, the third transistor T3 may be implemented with an NMOS, and the first transistor T1, the second transistor T2, the auxiliary transistor AT, the fourth transistor T4, the fifth transistor T5, the sixth transistor T6, and the seventh transistor T7 may be implemented with PMOSs.

Specifically, the first transistor T1 that directly affects the brightness of the display device may be configured to include a semiconductor layer including polycrystalline silicon having high reliability so that a display device having high resolution may be implemented.

Because the oxide semiconductor has high carrier mobility and a low leakage current, voltage drop may not be large even when a driving time is long. That is, since a color change of an image due to a voltage drop is not large even during low frequency driving, low frequency driving is possible. Because the oxide semiconductor has a low leakage current, the third transistor T3 or the fourth transistor T4 connected to the gate electrode of the first transistor T1 may be used as an oxide semiconductor to prevent a leakage current flowing to the gate electrode of the first transistor T1 while reducing power consumption.

The sub-pixel circuit PC is not limited to the number of thin film transistors and the number of storage capacitors and a circuit design described with reference to FIG. 2, and the numbers and the circuit design may be variously modified.

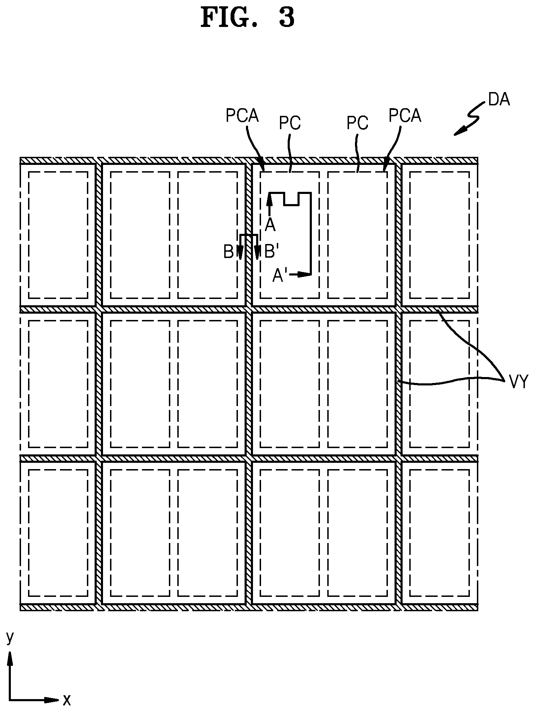

FIG. 3 is a plan view schematically illustrating a portion of a display area of the display device according to an embodiment.

Referring to FIG. 3, the display area DA may include sub-pixel circuit areas PCA in which sub-pixel circuits PC are arranged. The sub-pixel circuits PC may be arranged in a first direction (e.g., an x-direction) and a second direction (e.g., a y-direction).

Some sub-pixel circuits PC may be surrounded by a valleys VY in order to minimize generation of fine cracks in the sub-pixel circuits PC arranged in the display area DA that may be produced when a touch input such as a finger or a stylus pen is applied to the display area DA or an unintended pressure is applied to the display area DA. FIG. 3 illustrates that groups of two sub-pixel circuits PC are surrounded by the valleys VY.

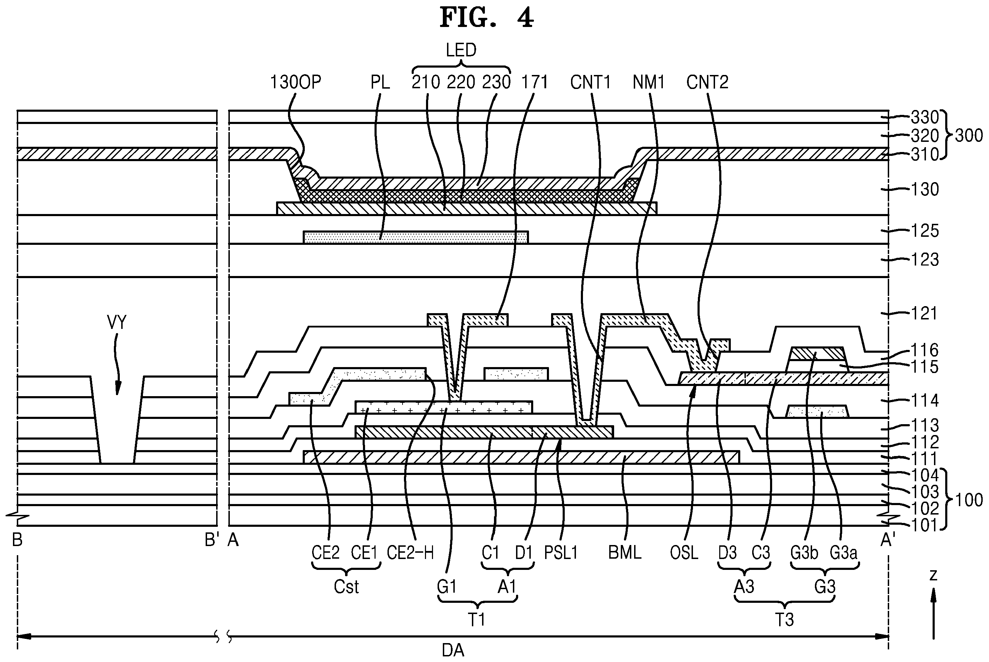

The valleys VY may be defined in at least one inorganic insulating layer included in the display device and may have a concave shape from an upper surface to a lower surface of at least one inorganic insulating layer described above. The at least one inorganic insulating layer may be at least one of the layers 111, 112, 113, 114 and/or 116, see e. g. FIG. 4. The valleys VY may be a kind of groove. The valleys VY are defined in at least one inorganic insulating layer that may easily crack during a touch input such as a finger or a stylus pen. The valleys VY prevent or reduce fine cracks from spreading to nearby sub-pixel circuit areas when an input device such as a pen is dropped on the display device 10 (Fig. 1). A display strain due to an external impact may be minimized by the valleys VY.

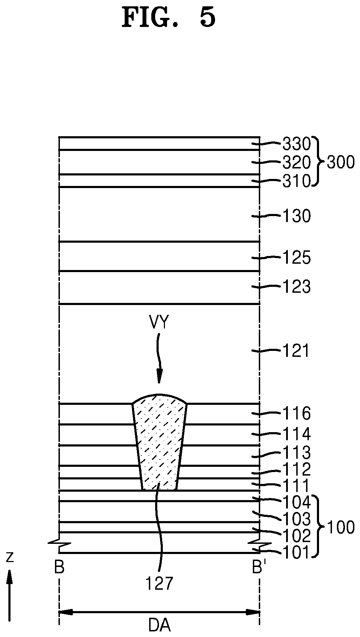

FIG. 4 is a cross-sectional view of the display device taken along line A-A' and line B-B' of FIG. 3, and FIG. 5 illustrates a modified embodiment of the display device taken along line B-B' of FIG. 3.

Referring to the cross-section taken line A-A' of FIG. 4, a substrate 100 may include a glass material, a ceramic material, a metal material, plastic or a material having flexible or bendable characteristics. When the substrate 100 has flexible or bendable characteristics, the substrate 100 may include a polymer resin such as polyethersulfone (PES), polyacrylate, polyetherimide (PEI), polyethylene naphthalate (PEN), polyethylene terephthalate (PET), polyphenylene sulfide (PPS), polyarylate, polyimide (PI), polycarbonate (PC), and cellulose acetate propionate (CAP).

The substrate 100 may have a single-layer or multi-layered structure of the material, and may further include an inorganic layer in the case of a multi-layered structure. For example, in a z direction, the substrate 100 may include a first organic base layer 101, a first inorganic barrier layer 102, a second organic base layer 103, and a second inorganic barrier layer 104. Each of the first organic base layer 101 and the second organic base layer 103 may include a polymer resin. The first inorganic barrier layer 102 and the second inorganic barrier layer 104 may be barrier layers for preventing the penetration of foreign substances, and may be a single layer or multiple layers including an inorganic insulating material such as silicon nitride or silicon oxide.

A lower metal layer BML may be disposed on the substrate 100. The lower metal layer BML may include one or more materials selected from the group consisting of aluminum (Al), platinum (Pt), palladium (Pd), silver (Ag), magnesium (Mg), gold (Au), nickel (Ni), neodymium (Nd), irridium (Ir), chromium (Cr), lithium (Li), calcium (Ca), molybdenum (Mo), titanium (Ti), tungsten (W), and copper (Cu). In some embodiments, the lower metal layer BML may have a single layer of Mo, a double-layer structure in which a Mo layer and a Ti layer are stacked, or a triple-layered structure in which a Ti layer, an A1 layer and a Ti layer are stacked.

The buffer layer 111 may be disposed on the lower metal layer BML. The buffer layer 111 may be an inorganic insulating layer including an inorganic insulating material such as silicon nitride or silicon oxide and may have a single layer or multiple layered structure including the above-described materials.

A semiconductor layer of silicon-based transistors may be disposed on the buffer layer 111. In this regard, FIG. 4 illustrates a first semiconductor layer A1 of a first transistor T1 corresponding to a portion of a first silicon semiconductor pattern PSL1. The first semiconductor layer A1 may include a first channel region C1 and impurity regions arranged at both sides of the first channel region C1 and doped with impurities, and in this regard, FIG. 4 illustrates a second region D1 that is one of the impurity regions arranged at one side of the first channel region C1.

The first gate electrode G1 may overlap the first semiconductor layer A1. In other words, the first gate electrode G1 may be arranged above the first semiconductor layer A1, wherein the first gate electrode G1 may have a smaller width than the first semiconductor layer A1. The width may be measured in the first or second direction. In other words, the first gate electrode G1 and the first semiconductor layer A1 may be in contact with each other and/or stacked.

A first gate insulating layer 112 may be disposed on the first silicon semiconductor pattern PSL1. The first gate insulating layer 112 may be an inorganic insulating layer including an inorganic insulating material such as silicon nitride or silicon oxide and may have a single layer or multiple layered structure including the above-described materials.

A first gate electrode G1 and a first capacitor electrode CE1 may be arranged on the first gate insulating layer 112. FIG. 4 illustrates that the first gate electrode G1 is integrally formed with the first capacitor electrode CE1. In other words, the first gate electrode G1 may perform a function of the first capacitor electrode CE1, or the first capacitor electrode CE1 may perform a function of the first gate electrode G1. But the first gate electrode G1 and the first capacitor electrode CE1 may be formed separately.

The first gate electrode G1 or the first capacitor electrode CE1 may include Al, Pt, Pd, Ag, Mg, Au, Ni, Nd, Ir, Cr, Li, Ca, Mo, Ti, W, or Cu, and may have a single layer or multilayered structure including the above-described materials.

A first interlayer insulating layer 113 may be arranged on the first gate electrode G1 or the first capacitor electrode CE1. The first interlayer insulating layer 113 may be an inorganic insulating layer including an inorganic insulating material such as silicon oxide, silicon nitride or silicon oxynitride and may have a single layer or multiple layered structure including the above-described materials.

The second capacitor electrode CE2 may be arranged on the first interlayer insulating layer 113. The second capacitor electrode CE2 may include Al, Pt, Pd, Ag, Mg, Au, Ni, Nd, Ir, Cr, Li, Ca, Mo, Ti, W or Cu, and may have a single layer or multilayered structure including the above-described materials. The second capacitor electrode CE2 may overlap the first gate electrode G1 or the first capacitor electrode CE1. The second capacitor electrode CE2 may include a hole CE2-H such that a node connection electrode 171 for electrically connecting the first gate electrode G1 of the first transistor T1 and the third transistor T3 to each other may be connected to the first gate electrode G1. The hole CE2-H may overlap a portion of the first gate electrode G1.

A second interlayer insulating layer 114 may be arranged on the second capacitor electrode CE2. The second interlayer insulating layer 114 may be an inorganic insulating layer including an inorganic insulating material such as silicon oxide, silicon nitride or silicon oxynitride and may have a single layer or multiple layered structure including the above-described materials.

Oxide semiconductor layers may be arranged on the second interlayer insulating layer 114. In this regard, FIG. 4 illustrates a third semiconductor layer A3 of the third transistor T3 corresponding to a portion of an oxide semiconductor pattern OSL. The third semiconductor layer A3 may include a third channel region C3 and conductive regions arranged at both sides of the third channel region C3, and in this regard, FIG. 4 illustrates a second region D3 that is one of the conductive regions arranged at one side of the third channel region C3. The third semiconductor layer A3 and the first semiconductor layer A1 may be arranged on different layers. For example, the first semiconductor layer A1 may be arranged on a buffer layer 111, and the third semiconductor layer A3 may be arranged on the second interlayer insulating layer 114. In other words, a vertical distance from the substrate 100 to the third semiconductor layer A3 may be greater than a vertical distance from the substrate 100 to the first semiconductor layer A1.

The third gate electrode G3 may be arranged under or on the third semiconductor layer A3. In an embodiment, FIG. 4 illustrates that the third gate electrode G3 includes a third lower gate electrode G3a arranged under the third semiconductor layer A3 and a third upper gate electrode G3b arranged on the third semiconductor layer A3. In another embodiment, one of the third lower gate electrode G3a and the third upper gate electrode G3b may be omitted.

The third lower gate electrode G3a may include the same material as a material of the second capacitor electrode CE2 and may be positioned on the same layer (e.g., the first interlayer insulating layer 113) as the second capacitor electrode CE2. The third upper gate electrode G3b may be disposed on the third semiconductor layer A3 with the second gate insulating layer 115 therebetween. The third upper gate electrode G3b may include Al, Pt, Pd, Ag, Mg, Au, Ni, Nd, Ir, Cr, Li, Ca, Mo, Ti, W or Cu, and may have a single layer or multilayered structure including the above-described materials.

FIG. 4 illustrates that the second gate insulating layer 115 is disposed between the third upper gate electrode G3b and the third semiconductor layer A3. However, embodiments of the present invention are not limited thereto. In another embodiment, the second gate insulating layer 115 may be formed to entirely cover the substrate 100 like another insulating layer, e.g., the first gate insulating layer 112. The second gate insulating layer 115 may be an inorganic insulating layer including an inorganic insulating material such as silicon nitride or silicon oxide and may have a single layer or multiple layered structure including the above-described materials.

A third interlayer insulating layer 116 may be arranged on the third upper gate electrode G3b. The third interlayer insulating layer 116 may be an inorganic insulating layer including an inorganic insulating material such as silicon oxide, silicon nitride or silicon oxynitride and may have a single layer or multiple layered structure including the above-described materials.

The node connection electrode 171 and the first connection electrode NM1 may be arranged on the third interlayer insulating layer 116. The node connection electrode 171 and the first connection electrode NM1 may include Al, Pt, Pd, Ag, Mg, Au, Ni, Nd, Ir, Cr, Li, Ca, Mo, Ti, W, or Cu, and may have a single layer or multilayered structure including the above-described materials.

The first connection electrode NM1 may be configured to electrically connect the first semiconductor layer A1 and the third semiconductor layer A3 to each other. The first connection electrode NM1 may be connected to a portion (e.g., the second region D1 of FIG. 4) of the first semiconductor layer A1 through a first contact hole CNT1 and may be connected to a portion (e.g., the second region D3 of FIG. 4) of the third semiconductor layer A3 through a second contact hole CNT2. The first contact hole CNT1 may pass through inorganic insulating layers, for example, the first gate insulating layer 112, the first interlayer insulating layer 113, the second interlayer insulating layer 114, and the third interlayer insulating layer 116 between the first semiconductor layer A1 and the first connection electrode NM1. The second contact hole CNT2 may pass through the third interlayer insulating layer 116 between the third semiconductor layer A3 and the first connection electrode NM1.

The lower metal layer BML may have a voltage level of a constant voltage. For example, the lower metal layer BML may be electrically connected to the driving voltage supply line (the driving voltage supply line 11 of FIG. 1) described with reference to FIG. 1 and may have the same voltage level (e.g., the driving voltage ELVDD of FIG. 2) as the driving voltage supply line (the driving voltage supply line 11 of FIG. 1). The lower metal layer BML may prevent (-) charges from being gathered under the first semiconductor layer A1 of the first transistor T1, thereby preventing or minimizing a problem in which an afterimage caused by (-) charges occurs.

A first organic insulating layer 121 may be formed on the first connection electrode NM1 and the node connection electrode 171. The first organic insulating layer 121 may include an organic material such as acryl, benzocyclobutene (BCB), polyimide or hexamethyldisiloxane (HMDSO).

The second organic insulating layer 123 may be disposed on the first organic insulating layer 121, and the driving voltage line PL may be disposed on the second organic insulating layer 123. The third organic insulating layer 125 may be disposed on the driving voltage line PL. The driving voltage line PL may include Al, Pt, Pd, Ag, Mg, Au, Ni, Nd, Ir, Cr, Li, Ca, Ti or W. In some embodiments, the driving voltage line PL may include a triple-layered structure of Ti layer, an Al layer, and a Ti layer.

Each of the second organic insulating layer 123 and the third organic insulating layer 125 may include an organic material such as BCB, polyimide or HMDSO.

The LED may be formed on the third organic insulating layer 125. The LED may include a first electrode 210, a light emitting layer 220, and a second electrode 230 on the third organic insulating layer 125. The light emitting layer 220 may include small molecular or polymer organic materials. At least one layer selected from a hole injection layer (HIL), a hole transport layer (HTL), an electron transport layer (ETL), or an electron injection layer (EIL) may be further disposed between the first electrode 210 and the second electrode 230.

An edge of the first electrode 210 may be covered by a bank layer 130, and the light emitting layer 220 may overlap an inner portion of the first electrode 210 through the opening 130OP of the bank layer 130. The first electrode 210 may be formed for each LED, whereas the second electrode 230 may be formed to correspond to a plurality of LEDs. In other words, the plurality of LEDs may share the second electrode 230, and a stacked structure of the first electrode 210, the light emitting layer 220, and a portion of the second electrode 230 may correspond to the LED.

An encapsulation layer 300 may be disposed on the LED. The encapsulation layer 300 may include at least one inorganic encapsulation layer and at least one organic encapsulation layer. FIG. 4 illustrates that the encapsulation layer 300 includes a first inorganic encapsulation layer 310, an organic encapsulation layer 320 and a second inorganic encapsulation layer 330, according to an embodiment. The first inorganic encapsulation layer 310 and the second inorganic encapsulation layer 330 may include silicon oxide, silicon nitride or silicon oxynitride, and the organic encapsulation layer 320 may include an organic insulating material.

Referring to the cross-section taken along line B-B' of FIG. 3 as shown in FIG. 4, the inorganic insulating layers arranged on the substrate 100 may include a valley VY provided between adjacent sub-pixel circuit areas PCA.

For example, the valley VY may pass through at least one selected from the group consisting of the inorganic insulating layers, e.g., the buffer layer 111, the first gate insulating layer 112, the first interlayer insulating layer 113, the second interlayer insulating layer 114 and the third interlayer insulating layer 116 on the substrate 100, as shown in FIG. 4. A first depth of the valley VY may be equal to or less than a sum of thicknesses of the buffer layer 111, the first gate insulating layer 112, the first interlayer insulating layer 113, the second interlayer insulating layer 114, and the third interlayer insulating layer 116.

At least a portion of the valley VY may be filled with an organic insulating material. For example, as shown in FIG. 4, a portion of the first organic insulating layer 121 disposed on the first and third transistors T1 and T3 may be present in the valley VY. A display device that is robust against an external impact (for example, an impact generated in an event of applying a certain pressure to a local area by such as a finger or a stylus pen) through a valley VY structure and flexible, may be provided. The valley VY may suppress generation of fine cracks and prevent propagation of fine cracks in a horizontal direction (e.g., a direction parallel to the upper surface of the substrate 100).

FIG. 4 illustrates that the organic insulating material for filling at least a portion of the valley VY is a portion of the first organic insulating layer 121. However, embodiments are not limited thereto.

In another embodiment, the organic insulating material for filling at least portion of the valley VY may be an organic insulating material that does not overlap transistors provided in a sub-pixel circuit. For example, as shown in FIG. 5, an organic insulating material 127 for filling at least a portion of the valley VY may be present only in the valley VY in the display area DA.

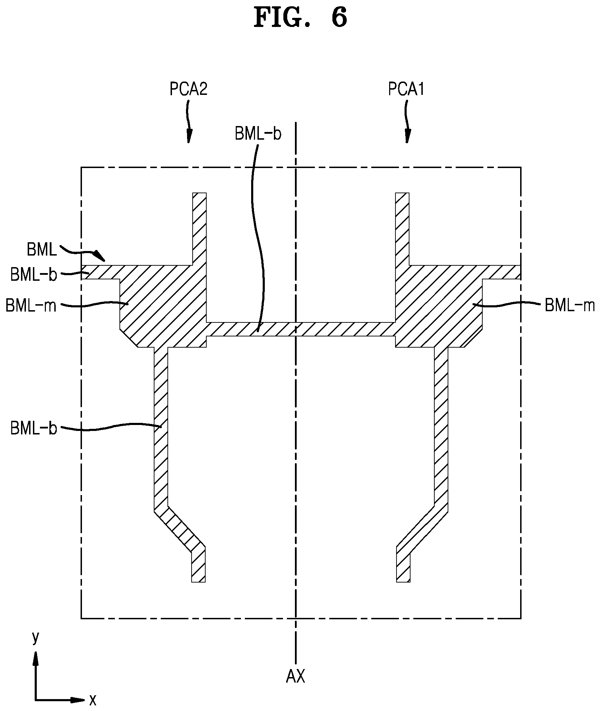

FIGS. 6 through 14 are plan views of components arranged in the display area of the display device of FIG. 1, according to processes of forming the components. For convenience of explanation, FIGS. 6 through 14 illustrate two sub-pixel circuits formed in two sub-pixel circuit areas arranged in a n-th row. For convenience of explanation, one of two sub-pixel circuit areas may be referred to as a first sub-pixel circuit area PCA1, and the other one thereof may be referred to as a second sub-pixel circuit area PCA2.

Referring to FIGS. 4 and 6, a lower metal layer BML may be formed on the substrate (100 of FIG. 4). The lower metal layer BML may include the material described above with reference to FIG. 4. For example, the lower metal layer BML may include metal such as molybdenum, titanium, or aluminum. The lower metal layer BML may be, for example, a single layer of Mo, a double layer of Mo and Ti, or a triple layer of a Ti layer, an Al layer, and a Ti layer.

The lower metal layer BML may include a portion (hereinafter, referred to as a main portion BML-m) positioned in each of first and second sub-pixel circuit areas PCA1 and PCA2, as shown in FIG. 6. Each main portion BML-m may be connected to other portions (hereinafter, referred to as branch portions BML-b) extending in the x-direction and the y-direction.

The lower metal layer BML positioned in the first and second sub-pixel circuit areas PCA1 and PCA2 may be substantially symmetrical to each other centered on a virtual line AX between the first and second sub-pixel circuit areas PCA1 and PCA2. The main portion BML-m disposed in the first sub-pixel circuit area PCA1 and a main portion BML-m disposed in the second sub-pixel circuit area PCA2 may be directly connected to each other.

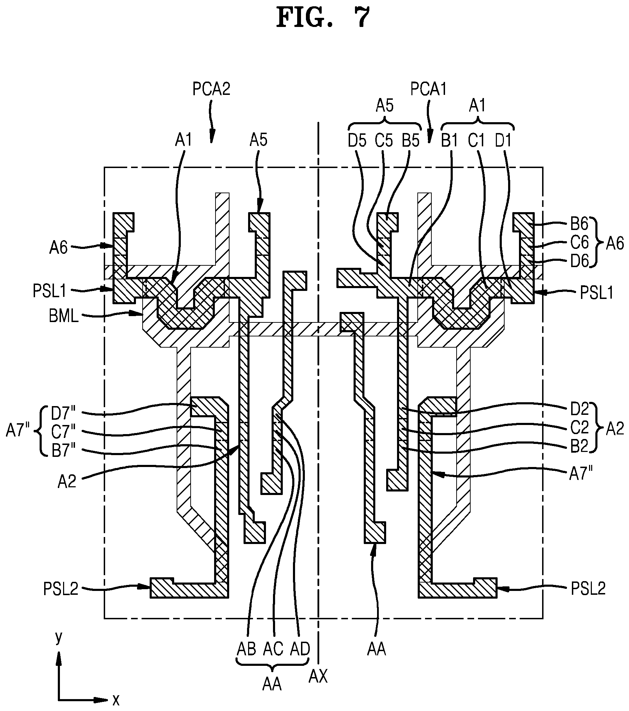

Referring to FIGS. 4 and 7, after the buffer layer (111 of FIG. 4) is formed on the lower metal layer BML, a silicon semiconductor pattern and an auxiliary semiconductor layer AA may be formed. In this regard, FIG. 7 illustrates a first silicon semiconductor pattern PSL1, a second silicon semiconductor pattern PSL2, and an auxiliary semiconductor layer AA, which are arranged in each of the first and second sub-pixel circuit areas PCA1 and PCA2. The first silicon semiconductor pattern PSL1 and the second silicon semiconductor pattern PSL2 arranged in the first sub-pixel circuit area PCA1 may be substantially symmetrical to the first silicon semiconductor pattern PSL1 and the second silicon semiconductor pattern PSL2 arranged in the second sub-pixel circuit area PCA2 centered on the virtual line AX. The first silicon semiconductor pattern PSL1 and the second silicon semiconductor pattern PSL2 may include silicon-based materials, for example, polycrystalline silicon.

The auxiliary semiconductor layer AA may be arranged in each of the first and second sub-pixel circuit areas PCA1 and PCA2. The auxiliary semiconductor layer AA arranged in the first sub-pixel circuit area PCA1 may not be symmetrical to the auxiliary semiconductor layer AA arranged in the second sub-pixel circuit area PCA2 centered on the virtual line AX. The auxiliary semiconductor layer AA may include a silicon-based material, for example, polycrystalline silicon. The first silicon semiconductor pattern PSL1, the second silicon semiconductor pattern PSL2, and the auxiliary semiconductor layer AA may include the same material. In other words, a first semiconductor layer A1, a second semiconductor layer A2, a fifth semiconductor layer A5, a sixth semiconductor layer A6, a seventh semiconductor layer A7", and an auxiliary semiconductor layer AA may include the same material. The first silicon semiconductor pattern PSL1, the second silicon semiconductor pattern PSL2, and the auxiliary semiconductor layer AA may be spaced apart from each other.

The first silicon semiconductor pattern PSL1 may be bent in various shapes, and as shown in FIG. 7, the first semiconductor layer A1 of the first transistor, the second semiconductor layer A2 of the second transistor, the fifth semiconductor layer A5 of the fifth transistor, and the sixth semiconductor layer A6 of the sixth transistor may be arranged along the first silicon semiconductor pattern PSL1. In other words, the first silicon semiconductor pattern PSL1 may include the first semiconductor layer A1, the second semiconductor layer A2, the fifth semiconductor layer A5, and the sixth semiconductor layer A6. The first semiconductor layer A1, the second semiconductor layer A2, the fifth semiconductor layer A5, and the sixth semiconductor layer A6 may be connected to each other and may be integrally formed.

The first semiconductor layer A1 may include a first channel region C1 and first and second regions B1 and D1, which are arranged at both sides of the first channel region C1. The first and second regions B1 and D1 of the first semiconductor layer A1 may be regions doped with impurities and may have higher electrical conductivity than the first channel region C1. One of the first and second regions B1 and D1 may be a source region, and the other one thereof may be a drain region. The first channel region C1 may have a curved shape (for example, an omega-shaped curved shape) on a plane, and may increase the length of the first channel region C1 in a narrow space according to the shape described above.

The first semiconductor layer A1 may overlap the lower metal layer BML. For example, the first channel region C1 of the first semiconductor layer A1 may overlap the lower metal layer BML. For example, the first channel region C1 of the first semiconductor layer A1 may overlap the main portion BML-m that is a portion of the lower metal layer BML.

The second semiconductor layer A2 may include a second channel region C2, and first and second regions B2 and D2, which are arranged at both sides of the second channel region C2. The first and second regions B2 and D2 of the second semiconductor layer A2 may be regions doped with impurities and may have higher electrical conductivity than the second channel region C2. One of the first and second regions B2 and D2 may be a source region, and the other one thereof may be a drain region.

The fifth semiconductor layer A5 may include a fifth channel region C5, and first and second regions B5 and D5, which are arranged at both sides of the fifth channel region C5. The first and second regions B5 and D5 of the fifth semiconductor layer A5 may be regions doped with impurities and have greater electrical conductivity than the fifth channel region C5, and one of the first and second regions B5 and D5 may be a source region, and the other one thereof may be a drain region.

The sixth semiconductor layer A6 may include a sixth channel region C6, and first and second regions B6 and D6, which are arranged at both sides of the sixth channel region C6. The first and second regions B6 and D6 of the sixth semiconductor layer A6 may be regions doped with impurities and have greater electrical conductivity than the sixth channel region C6, and one of the first and second regions B6 and D6 may be a source region, and the other one thereof may be a drain region.

In an embodiment, the first region B1 of the first semiconductor layer A1 may be connected integrally with the second region D2 of the second semiconductor layer A2 and the second region D5 of the fifth semiconductor layer A5. The second region D1 of the first semiconductor layer A1 may be connected integrally with the second region D6 of the sixth semiconductor layer A6.

A seventh semiconductor layer A7" of the seventh transistor may be formed along the second silicon semiconductor pattern PSL2. The seventh semiconductor layer A7" of the seventh transistor arranged in each of the first and second sub-pixel circuit areas PCA1 and PCA2 may correspond to a seventh semiconductor layer of a seventh transistor of a sub-pixel circuit arranged in a next row of an n-th row in which the first and second sub-pixel circuit areas PCA1 and PCA2 are arranged, i.e., a (n+1)-th row. The seventh semiconductor layer A7" of the seventh transistor corresponding to each of the first and second sub-pixel circuit areas PCA1 and PCA2 may be positioned in a sub-pixel circuit area in a (n-1)-th row.

The seventh semiconductor layer A7" may include a seventh channel region C7", and first and second regions B7" and D7", which are arranged at both sides of the seventh channel region C7". The first and second regions B7" and D7" of the seventh semiconductor layer A7" may be regions doped with impurities and have greater electrical conductivity than the seventh channel region C7", and one of the first and second regions B7" and D" may be a source region, and the other one thereof may be a drain region.

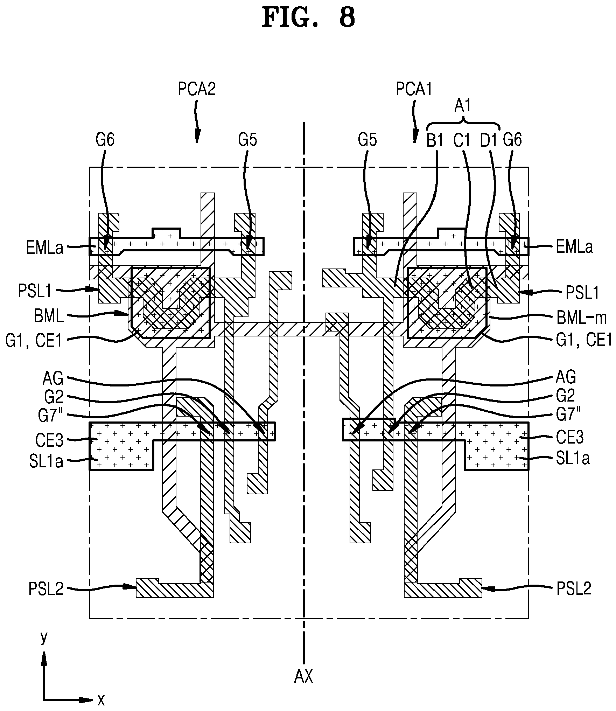

Referring to FIGS. 4 and 8, a first gate insulating layer 112 may be formed on the first and second silicon semiconductor patterns PSL1 and PSL2, and a first gate electrode G1 of the first transistor, a second gate electrode G2 of the second transistor, a fifth gate electrode G5 of the fifth transistor, a sixth gate electrode G6 of the sixth transistor, and a seventh gate electrode G7" of the seventh transistor may be arranged on the first gate insulating layer 112. A first capacitor electrode CE1, a first auxiliary scan line SL1a, and an auxiliary emission control line EMLa may be arranged on the first gate insulating layer 112.

The first gate electrode G1 may have an isolated shape on a plane, and the first gate electrode G1 may include the first capacitor electrode CE1. In other words, the first gate electrode G1 and the first capacitor electrode CE1 may be integrally formed, and the first capacitor electrode CE1 may include the first gate electrode G1.

The first gate electrode G1 or the first capacitor electrode CE1 may be formed to entirely cover the first channel region C1 of the first semiconductor layer A1. The main portion BML-m of the lower metal layer BML may have a greater area than the first gate electrode G1 or the first capacitor electrode CE1. The main portion BML-m of the lower metal layer BML may entirely overlap the first channel region C1 of the first semiconductor layer A1.

The first gate electrode G1 or the first capacitor electrode CE1 arranged in the first and second sub-pixel circuit areas PCA1 and PCA2 may be substantially symmetrical to each other centered on the virtual line AX between the first and second sub-pixel circuit areas PCA1 and PCA2. A first auxiliary scan line SL1a arranged in the first sub-pixel circuit area PCA1 and the first auxiliary scan line SL1a arranged in the second sub-pixel circuit area PCA2 may be arranged at both sides of the virtual line AX and may be spaced apart from each other centered on the virtual line AX. An auxiliary emission control line EMLa arranged in the first sub-pixel circuit area PCA1 and the auxiliary emission control line EMLa arranged in the second sub-pixel circuit area PCA2 may be arranged at both sides of the virtual line AX and may be spaced apart from each other centered on the virtual line AX. In some embodiments, one of the first auxiliary scan lines SL1a disposed in the first and second sub-pixel circuit areas PCA1 and PCA2 may be called as a first auxiliary scan line, and the other of the first auxiliary scan lines SL1a disposed in the first and second sub-pixel circuit areas PCA1 and PCA2 may be called as a second auxiliary scan line. For example, the first auxiliary scan line SL1a disposed in the first sub-pixel circuit area PCA1 may be called as a first auxiliary scan line, and the first auxiliary scan line SL1a disposed in the second sub-pixel circuit area PCA2 may also be called as a second auxiliary scan line.

Each of the first auxiliary scan line SL1a and the auxiliary emission control line EMLa may extend in the x-direction. The first auxiliary scan line SL1a and the auxiliary emission control line EMLa may be spaced apart from each other with the first gate electrode G1 or the first capacitor electrode CE1 therebetween on the plane.

The first auxiliary scan line SL1a may include an auxiliary gate electrode AG, a second gate electrode G2, a seventh gate electrode G7", and a third capacitor electrode CE3. A portion of the first auxiliary scan line SL1a may include a portion having a greater width than another portion in the y-direction, and the portion having a relatively large width may correspond to the third capacitor electrode CE3. The auxiliary emission control line EMLa may include a fifth gate electrode G5 and a sixth gate electrode G6. The seventh gate electrodes G7" arranged in each of the first and second sub-pixel circuit areas PCA1 and PCA2 may correspond to a gate electrode of a seventh transistor of a sub-pixel circuit arranged in a next row of an n-th row in which the first and second sub-pixel circuit areas PCA1 and PCA2 are arranged, i.e., a (n+1)-th row.

The first auxiliary scan line SL1a and the auxiliary emission control line EMLa may include the same material as the first gate electrode G1 or the first capacitor electrode CE1, and a detailed material thereof is as described above with reference to FIG. 4.

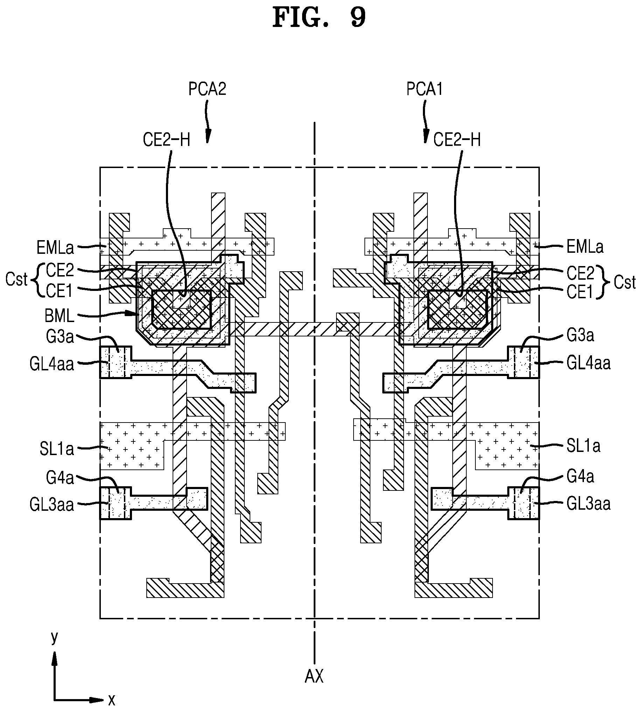

Referring to FIGS. 4 and 9, after a first interlayer insulating layer (113 of FIG. 4) is formed on a structure of FIG. 8, a second capacitor electrode CE2, a third lower gate line GL3aa, and a fourth lower gate line GL4aa may be formed. The third lower gate line GL3aa arranged in the first sub-pixel circuit area PCA1 and the third lower gate line GL3aa arranged in the second sub-pixel circuit area PCA2 may be arranged at both sides of the virtual line AX and may be spaced apart from each other centered on the virtual line AX. The fourth lower gate line GL4aa arranged in the first sub-pixel circuit area PCA1 and the fourth lower gate line GL4aa arranged in the second sub-pixel circuit area PCA2 may be arranged at both sides of the virtual line AX and may be spaced apart from each other centered on the virtual line AX..

The second capacitor electrode CE2 may overlap the first capacitor electrode CE1 and may include a hole CE2-H for exposing a portion of the first capacitor electrode CE1. The hole CE2-H may have a structure that is entirely surrounded by a material portion that constitutes the second capacitor electrode CE2. In other words, the second capacitor electrode CE2 may have a donut shape on the plane. The first capacitor electrode CE1 and the second capacitor electrode CE2 may constitute the first capacitor Cst.

Each of the third lower gate line GL3aa and the fourth lower gate line GL4aa may extend in the x-direction. The third lower gate line GL3aa and the fourth lower gate line GL4aa may be spaced apart from each other with the first auxiliary scan line SL1a therebetween. The fourth lower gate line GL4aa may include a third lower gate electrode G3a, and the third lower gate line GL3aa may include a fourth lower gate electrode G4a.

The second capacitor electrode CE2, the third lower gate line GL3aa, and the fourth lower gate line GL4aa may include the same material and may be arranged on the same layer (e.g., the first interlayer insulating layer (113 of FIG. 4). The material for forming the third lower gate line GL3aa and the fourth lower gate line GL4aa may be the same material as the second capacitor electrode CE2 described above with reference to FIG. 4.

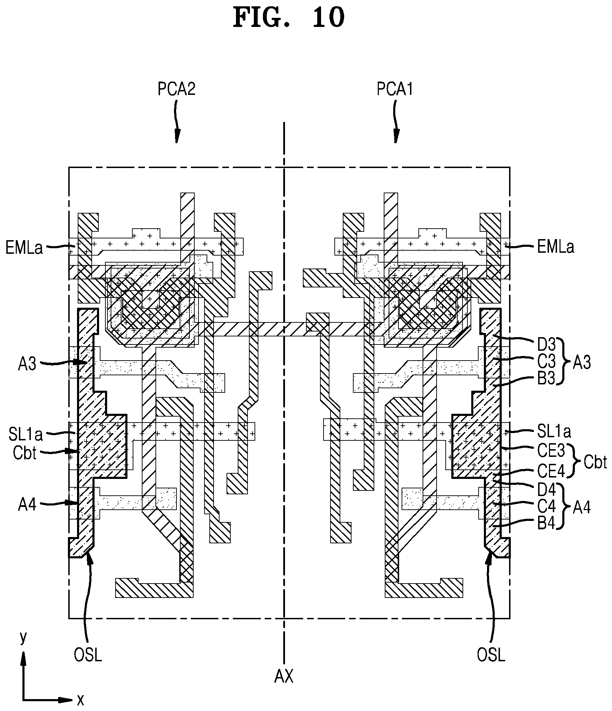

Referring to FIGS. 4 and 10, after a second interlayer insulating layer (114 of FIG. 4) is formed on a structure of FIG. 9, an oxide semiconductor pattern OSL may be formed. The oxide semiconductor pattern OSL arranged in each of the first and second sub-pixel circuit areas PCA1 and PCA2 may be substantially symmetrical to each other centered on the virtual line AX between the first and second sub-pixel circuit areas PCA1 and PCA2.

In this regard, FIG. 10 illustrates the oxide semiconductor pattern OSL arranged in each of the first and second sub-pixel circuit areas PCA1 and PCA2. The oxide semiconductor pattern OSL may be formed of an oxide-based semiconductor material, for example, Zn oxide, In-Zn oxide, and Ga-In-Zn oxide. In some embodiments, the oxide semiconductor pattern OSL may include an In-Ga-Zn-O (IGZO) semiconductor in which a metal such as indium (In), gallium (Ga) and tin (Sn) is included in ZnO, an In-Sn-Zn-O (ITZO) semiconductor, or an In-Ga-Sn-Zn-O (IGTZO) semiconductor.

The oxide semiconductor pattern OSL may include a third semiconductor layer A3 of the third transistor and a fourth semiconductor layer A4 of the fourth transistor. The third semiconductor layer A3 and the fourth semiconductor layer A4 may be connected to each other and may be integrally formed.

The third semiconductor layer A3 may include a third channel region C3, and first and second regions B3 and D3, which are arranged at both sides of the third channel region C3. The first and second regions B3 and D3 of the third semiconductor layer A3 may be conductive regions and may have higher electrical conductivity than the third channel region C3. One of the first and second regions B3 and D3 may be a source region, and the other one thereof may be a drain region.

The fourth semiconductor layer A4 may include a fourth channel region C4, and first and second regions B4 and D4, which are arranged at both sides of the fourth channel region C4. The first and second regions B4 and D4 of the fourth semiconductor layer A4 may be conductive regions and may have higher electrical conductivity than the fourth channel region C4. One of the first and second regions B4 and D4 may be a source region, and the other one thereof may be a drain region.

The oxide semiconductor pattern OSL may include a fourth capacitor electrode CE4. A portion of the oxide semiconductor pattern OSL that overlaps the third capacitor electrode (CE3 of FIG. 8) may correspond to the fourth capacitor electrode CE4. The third capacitor electrode CE3 and the fourth capacitor electrode CE4 may constitute the second capacitor Cbt.

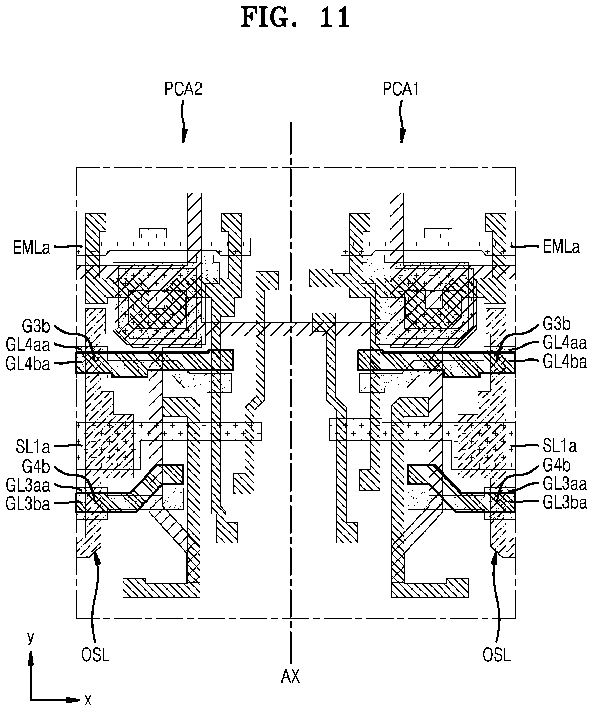

Referring to FIGS. 4 and 11, a third upper gate line GL3ba and a fourth upper gate line GL4ba may be formed on a structure of FIG. 10. The third upper gate line GL3ba of the first sub-pixel circuit area PCA1 and the third upper gate line GL3ba of the second sub-pixel circuit area PCA2 may be arranged at both sides of the virtual line AX and may be spaced apart from each other. The fourth upper gate line GL4ba of the first sub-pixel circuit area PCA1 and the fourth upper gate line GL4ba of the second sub-pixel circuit area PCA2 may be arranged at both sides of the virtual line AX and may be spaced apart from each other.

At least a portion of the fourth upper gate line GL4ba may overlap the fourth lower gate line GL4aa with the oxide semiconductor pattern OSL therebetween. The fourth upper gate line GL4ba may include a third upper gate electrode G3b.

At least a portion of the third upper gate line GL3ba may overlap the third lower gate line GL3aa with the oxide semiconductor pattern OSL therebetween. The third upper gate line GL3ba may include a fourth upper gate electrode G4b.

The fourth upper gate electrode G4b, the third upper gate line GL3ba, and the fourth upper gate line GL4ba may include the same material as the third upper gate electrode G3b described above with reference to FIG. 4.

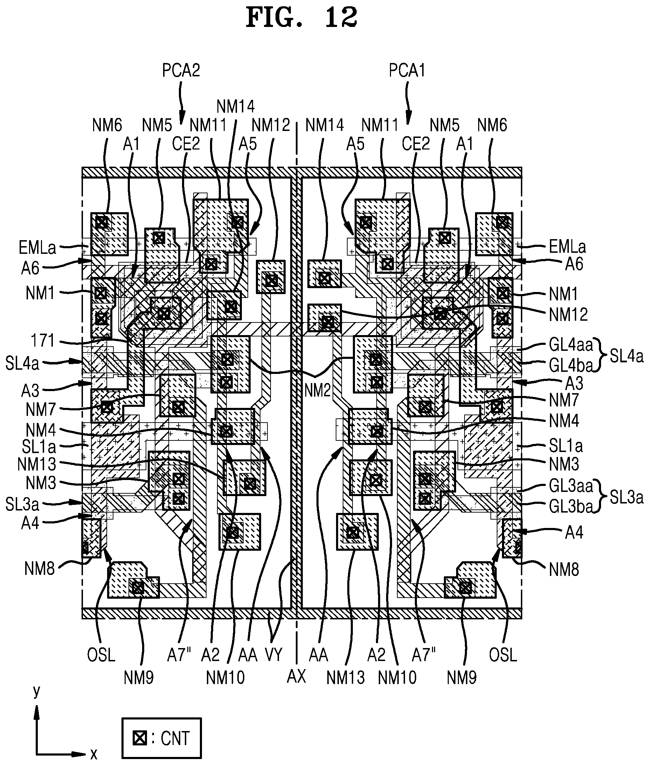

Referring to FIGS. 4 and 12, after a third interlayer insulating layer (116 of FIG. 4) is formed on a structure of FIG. 11, first through fourteenth connection electrodes NM1, NM2, NM3, NM4, NM5, NM6, NM7, NM8, NM9, NM10, NM11, NM12, NM13, and NM14, and a node connection electrode 171 may be formed. The first through fourteenth connection electrodes NM1, NM2, NM3, NM4, NM5, NM6, NM7, NM8, NM9, NM10, NM11, NM12, NM13, and NM14 and the node connection electrode 171 may include the same material. For example, the first through fourteenth connection electrodes NM1, NM2, NM3, NM4, NM5, NM6, NM7, NM8, NM9, NM10, NM11, NM12, NM13, and NM14 and the node connection electrode 171 may include Al, Pt, Pd, Ag, Mg, Au, Ni, Nd, Ir, Cr, Li, Ca, Mo, Ti, W, or Cu, and may have a single layer or multilayered structure including the above-described materials.

The first connection electrode NM1 may be configured to electrically connect the first semiconductor layer A1 of the first silicon semiconductor pattern and the third semiconductor layer A3 of the oxide semiconductor pattern OSL to each other. The first connection electrode NM1 may be connected to the second region (see D1 of FIG. 7) that is a portion of the first semiconductor layer A1 through a contact hole CNT and may be connected to a second region (see D3 of FIG. 10) that is a portion of the third semiconductor layer A3 through the contact hole CNT.

The second connection electrode NM2 may be configured to electrically connect the fourth lower gate line GL4aa and the fourth upper gate line GL4ba to each other by using contact holes CNT. The fourth lower gate line GL4aa and the fourth upper gate line GL4ba may constitute a fourth auxiliary scan line SL4a.

The third connection electrode NM3 may be configured to electrically connect the third lower gate line GL3aa and the third upper gate line GL3ba to each other by using the contact holes CNT. The third lower gate line GL3aa and the third upper gate line GL3ba may constitute a third auxiliary scan line SL3a.

The fourth connection electrode NM4 may be connected to the first auxiliary scan line SL1a, and the fifth connection electrode NM5 may be connected to the auxiliary emission control line EMLa. A sixth connection electrode NM6 may be connected to a portion of the sixth semiconductor layer A6, and a seventh connection electrode NM7 may be connected to a portion of the seventh semiconductor layer A7". An eighth connection electrode NM8 may be connected to a portion of the fourth semiconductor layer A4. A ninth connection electrode NM9 may be connected to another portion of the seventh semiconductor layer A7". A tenth connection electrode NM10 may be connected to the second semiconductor layer A2, and an eleventh connection electrode NM11 may be connected to the second capacitor electrode CE2 and the fifth semiconductor layer A5. A twelfth connection electrode NM12 and a thirteenth connection electrode NM13 may be connected to both ends of the auxiliary semiconductor layer AA, respectively. A fourteenth connection electrode NM14 may be connected to a portion of the first semiconductor layer A1.

One end of the node connection electrode 171 may be connected to the first gate electrode G1 through the hole (CE2-H of FIG. 9) of the second capacitor electrode CE2, and the other end of the node connection electrode 171 may be connected to the third semiconductor layer A3.

Each of the first and second sub-pixel circuit areas PCA1 and PCA2 may be surrounded by the valley VY on the plane. The valley VY of FIG. 12 may be the valley VY described above with reference to FIG. 4 or 5, and the valley VY formed by removing a portion of each of inorganic insulating layers may be at least partially filled by an organic insulating material.

Referring to FIGS. 4, 12, and 13, after the first organic insulating layer (121 of FIG. 4) is formed on a structure of FIG. 12, a first scan line SL1, a third scan line SL3, a fourth scan line SL4, an emission control line EML, a first initialization voltage line VIL1, a second initialization voltage line VIL2", a horizontal voltage line H-PL, first connection lines CL1, second connection lines CL2, and vertical connection lines ML and ML" may be formed on the first organic insulating layer (121 of FIG. 4). The first scan line SL1, the third scan line SL3, the fourth scan line SL4, an emission control line EML, the first initialization voltage line VIL1, the second initialization voltage line VIL2", the horizontal voltage line H-PL, the first connection lines CL1, and the second connection lines CL2 may extend in the x-direction to cross the valley VY.

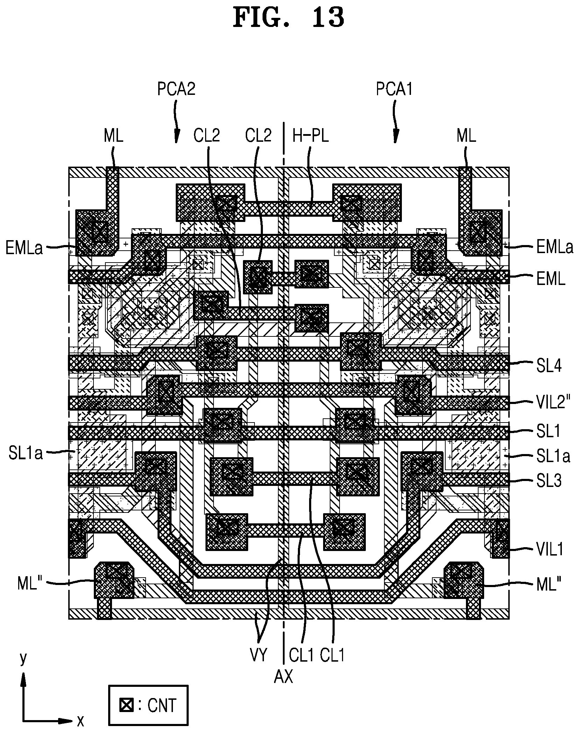

The first scan line SL1 may be connected to a fourth connection electrode (NM4 of FIG. 12) through the contact hole CNT. The first scan line SL1 may be electrically connected to the first auxiliary scan lines SL1a via the fourth connection electrode (NM4 of FIG. 12). As shown in FIG. 12, the first auxiliary scan lines SL1a arranged in each of the first and second sub-pixel circuit areas PCA1 and PCA2 may extend in the x-direction and may be sapced apart from each other with the valley VY therebetween. On the other hand, the first scan line SL1 shown in FIG. 13 may extend in the x-direction, may cross the valley VY and may be electrically connected to each first auxiliary scan line SL1a through the fourth connection electrode (NM4 of FIG. 12).

The third scan line SL3 may be connected to a third connection electrode (NM3 of FIG. 12) through the contact hole CNT. The third scan line SL3 may be electrically connected to the third auxiliary scan lines (SL3a of FIG. 12) via the third connection electrode (NM3 of FIG. 12). As shown in FIG. 12, the third auxiliary scan lines SL3a arranged in each of the first and second sub-pixel circuit areas PCA1 and PCA2 may extend in the x-direction and may be spaced apart from each other with the valley VY therebetween. On the other hand, the third scan line SL3 shown in FIG. 13 may extend in the x-direction, may cross the valley VY and may be electrically connected to each third auxiliary scan line (SL3a of FIG. 12) through the third connection electrode (NM3 of FIG. 12).

The fourth scan line SL4 may be connected to a second connection electrode (NM2 of FIG. 12) through the contact hole CNT. The fourth scan line SL4 may be electrically connected to the fourth auxiliary scan lines (SL4a of FIG. 12) via the second connection electrode (NM2 of FIG. 12). As shown in FIG. 12, the fourth auxiliary scan lines SL4a arranged in each of the first and second sub-pixel circuit areas PCA1 and PCA2 may extend in the x-direction and may be spaced apart from each other with the valley VY therebetween. On the other hand, the fourth scan line SL4 shown in FIG. 13 may extend in the x-direction, may cross the valley VY and may be electrically connected to each fourth auxiliary scan line (SL4a of FIG. 12) through the second connection electrode (NM2 of FIG. 12).

The emission control line EML may be connected to a fifth connection electrode (NM5 of FIG. 12) through the contact hole CNT. The emission control line EML may be electrically connected to the auxiliary emission control line (EMLa of FIG. 12) via the fifth connection electrode (NM5 of FIG. 12). As shown in FIG. 12, the auxiliary emission control line EMLa arranged in each of the first and second sub-pixel circuit areas PCA1 and PCA2 may extend in the x-direction and may be spaced apart from each other with the valley VY therebetween. On the other hand, the emission control line EML shown in FIG. 13 may extend in the x-direction, may cross the valley VY and may be electrically connected to each auxiliary emission control line EMLa through the fifth connection electrode (NM5 of FIG. 12).

The first initialization voltage line VIL1 may be connected to the eighth connection electrode (NM8 of FIG. 12) through the contact hole CNT, and the second initialization voltage line VIL2" may be connected to the seventh connection electrode (NM7 of FIG. 12) through the contact hole CNT. The first initialization voltage line VIL1 may provide a first initialization voltage to the fourth transistor (T4 of FIG. 3). The second initialization voltage line VIL2" may provide a second initialization voltage to the seventh transistor of the sub-pixel circuit arranged in the (n+1)-th row.

The horizontal voltage line H-PL may be connected to the eleventh connection electrode (NM11 of FIG. 12) through the contact hole CNT. The horizontal voltage line H-PL may be electrically connected to the fifth semiconductor layer (A5 of FIG. 12) and the second capacitor electrode (CE2 of FIG. 12) via the eleventh connection electrode (NM11 of FIG. 12). The horizontal voltage line H-PL may extend in the x-direction and may cross the valley VY.

Each first connection line CL1 may extend in the x-direction and may cross the valley VY. The first connection line CL1 may be connected to the thirteenth connection electrode (NM13 of FIG. 12) of any one sub-pixel circuit area selected from the first sub-pixel circuit area PCA1 and the second sub-pixel circuit area PCA2, and the tenth connection electrode (NM10 of FIG. 12) of the other sub-pixel circuit area selected from the first sub-pixel circuit area PCA1 and the second sub-pixel circuit area PCA2. Each first connection line CL1 may be connected to the thirteenth connection electrode (NM13 of FIG. 12) and the tenth connection electrode (NM10 of FIG. 12) through the contact hole CNT formed in the insulating layer (e.g., the first organic insulating layer (121 of FIG. 4) interposed between the tenth and thirteenth connection electrodes NM10 and NM13 of FIG. 12.

Each second connection line CL2 may extend in the x-direction and may cross the valley VY. The second connection line CL2 may be connected to the twelfth connection electrode (NM12 of FIG. 12) of any one sub-pixel circuit area selected from the first sub-pixel circuit area PCA1 and the second sub-pixel circuit area PCA2, and the fourteenth connection electrode (NM14 of FIG. 12) of the other sub-pixel circuit area selected from the first sub-pixel circuit area PCA1 and the second sub-pixel circuit area PCA2. Each second connection line CL2 may be connected to the twelfth connection electrode (NM12 of FIG. 12) and the fourteenth connection electrode (NM14 of FIG. 12) through the contact hole CNT formed in the insulating layer (e.g., the first organic insulating layer (121 of FIG. 4) interposed between the twelfth and fourteenth connection electrodes NM12 and NM14 of FIG. 12.

Vertical connection lines ML and ML" may extend in the y-direction and may cross the valley VY. The vertical connection line ML arranged at an upper side of the first and second sub-pixel circuit areas PCA1 and PCA2 may be configured to electrically connect the sixth semiconductor layer (A6 of FIG. 12) corresponding to the sixth transistor to the seventh semiconductor layer of the seventh transistor arranged in the (n-1)-th row. The vertical connection line ML" arranged at a lower side of the first and second sub-pixel circuit areas PCA1 and PCA2 may be configured to electrically connect the seventh semiconductor layer (A7" of FIG. 12) arranged in each of the first and second sub-pixel circuit areas PCA1 and PCA2 and the sixth semiconductor layer of the sixth transistor arranged in the (n+1)-th row.

The first scan line SL1, the third scan line SL3, the fourth scan line SL4, the emission control line EML, the first initialization voltage line VIL1, the second initialization voltage line VIL2", the horizontal voltage line H-PL, the first connection lines CL1, the second connection lines CL2, and the vertical connection lines ML and ML" may be formed. The first scan line SL1, the third scan line SL3, the fourth scan line SL4, the emission control line EML, the first initialization voltage line VIL1, the second initialization voltage line VIL2", the horizontal voltage line H-PL, the first connection lines CL1, the second connection lines CL2, and the vertical connection lines ML and ML" may include Al, Pt, Pd, Ag, Mg, Au, Ni, Nd, Ir, Cr, Li, Ca, Mo, Ti, W or Cu, and may have a single layer or multilayered structure including the above-described materials. The first scan line SL1, the third scan line SL3, the fourth scan line SL4, the emission control line EML, the first initialization voltage line VIL1, the second initialization voltage line VIL2", the horizontal voltage line H-PL, the first connection lines CL1, the second connection lines CL2, and the vertical connection lines ML and ML" may include the same material. For example, the first scan line SL1, the third scan line SL3, the fourth scan line SL4, the emission control line EML, the first initialization voltage line VIL1, the second initialization voltage line VIL2", the horizontal voltage line H-PL, the first connection lines CL1, the second connection lines CL2, and the vertical connection lines ML and ML" may include a triple-layered structure in which a Ti layer, an Al layer and a Ti layer are stacked.

Referring to FIGS. 4, 13, and 14, after a second organic insulating layer (123 of FIG. 4) is formed on a structure of FIG. 13, a data line DL and a driving voltage line PL may be formed. The data line DL and the driving voltage line PL may extend in the y-direction.

The data line DL that passes through the first sub-pixel circuit area PCA1 may be connected to the first connection line (CL1 of FIG. 13). The data line DL passing through the first sub-pixel circuit area PCA1 may be electrically connected to the second semiconductor layer (A2 of FIG. 12) disposed in the first sub-pixel circuit area PCA1 through a portion of the first connection line (CL1 of FIG. 13) and the tenth connection electrode (NM10 of FIG. 12) disposed in the first sub-pixel circuit area PCA1.

The first connection line (CL1 of FIG. 13) electrically connected to a data line DL passing through the first sub-pixel circuit area PCA1 may extend toward the second sub-pixel circuit area PCA2, and the other part of the first connection line (CL1 of FIG. 13) positioned in the second sub-pixel circuit area PCA2 may be connected to the thirteenth connection electrode (NM13 of FIG. 12) positioned in the second sub-pixel circuit area PCA2. Thus, the data line DL passing through the first sub-pixel circuit area PCA1 may be electrically connected to the auxiliary semiconductor layer (AA of FIG. 12) positioned in the second sub-pixel circuit area PCA2 through the first connection line (CL1 of FIG. 13) extending toward the second sub-pixel circuit area PCA2 and the thirteenth connection electrode (NM13 of FIG. 12) disposed in the second sub-pixel circuit area PCA2.

The data line DL that passes through the second sub-pixel circuit area PCA2 may be connected to the first connection line (CL1 of FIG. 13). The data line DL passing through the second sub-pixel circuit area PCA2 may be electrically connected to the second semiconductor layer (A2 of FIG. 12) disposed in the second sub-pixel circuit area PCA2 through a portion of the first connection line (CL1 of FIG. 13) and the tenth connection electrode (NM10 of FIG. 12) disposed in the second sub-pixel circuit area PCA2.

The first connection line (CL1 of FIG. 13) electrically connected to a data line DL passing through the second sub-pixel circuit area PCA2 may extend toward the first sub-pixel circuit area PCA1, and the other part of the first connection line (CL1 of FIG. 13) positioned in the first sub-pixel circuit area PCA1 may be connected to the thirteenth connection electrode (NM13 of FIG. 12) positioned in the first sub-pixel circuit area PCA1. Thus, the data line DL passing through the second sub-pixel circuit area PCA2 may be electrically connected to the auxiliary semiconductor layer (AA of FIG. 12) positioned in the first sub-pixel circuit area PCA1 through the first connection line (CL1 of FIG. 13) extending toward the first sub-pixel circuit area PCA1 and the thirteenth connection electrode (NM13 of FIG. 12) disposed in the first sub-pixel circuit area PCA1.

The driving voltage line PL may be connected to the horizontal voltage line (H-PL of FIG. 12). The horizontal voltage line (H-PL of FIG. 13) may be connected to the eleventh connection electrode (NM11 of FIG. 13) thereunder. The driving voltage line PL may be configured to be electrically connected to the second capacitor electrode (CE2 of FIG. 12) and the fifth semiconductor layer (A5 of FIG. 12) via the horizontal voltage line (H-PL of FIG. 13) and the eleventh connection electrode (NM11 of FIG. 12).

The data line DL and the driving voltage line PL may extend in the y-direction and may cross the valley VY. The data line DL and the driving voltage line PL may include Al, Pt, Pd, Ag, Mg, Au, Ni, Nd, Ir, Cr, Li, Ca, Mo, Ti, W, or Cu, and may have a single layer or multilayered structure including the above-described materials. The data line DL and the driving voltage line PL may include the same material. In an embodiment, the data line DL and the driving voltage line PL may include a structure in which a Ti layer, an Al layer and a Ti layer are stacked.

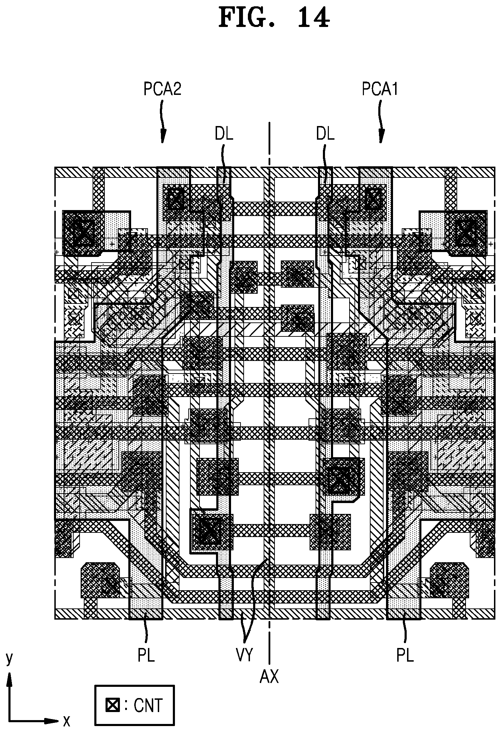

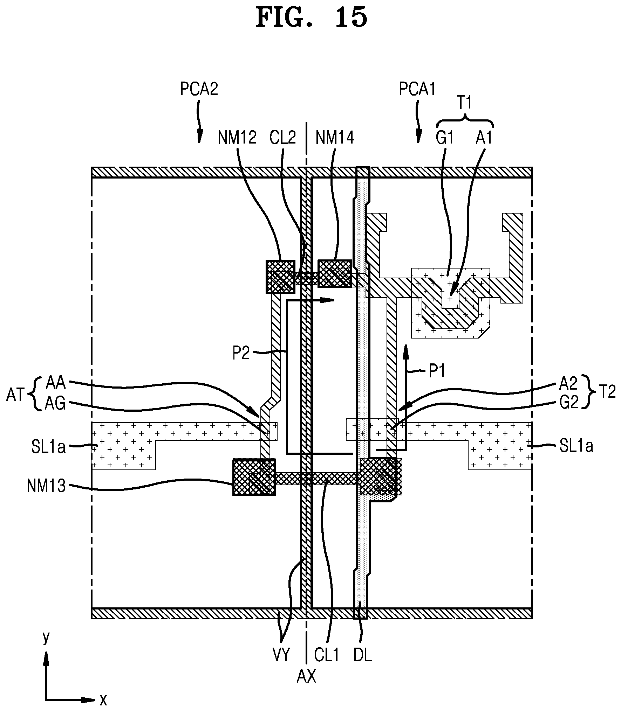

FIG. 15 is an extracted plan view illustrating a portion of a first transistor and a second transistor arranged in a first sub-pixel circuit area of the display device shown in FIG. 14 and an auxiliary transistor arranged in a second sub-pixel circuit area of the display device of FIG. 14.

The first transistor T1 disposed in the first sub-pixel circuit area PCA1 may be electrically connected to the second transistor T2 and the auxiliary transistor AT disposed in the second sub-pixel circuit area PCA2. The first transistor T1 may include a first semiconductor layer A1 and a first gate electrode G1, and the second transistor T2 may include a second semiconductor layer A2 and a second gate electrode G2. The first semiconductor layer A1 of the first transistor T1 may be integral with the second semiconductor layer A2 of the second transistor T2.

The auxiliary transistor AT may include an auxiliary semiconductor layer AA and an auxiliary gate electrode AG disposed in the second sub-pixel circuit area PCA2. The auxiliary semiconductor layer AA of the auxiliary transistor AT may be spaced apart from the first semiconductor layer A1 of the first transistor T1 and the second semiconductor layer A2 of the second transistor T2 disposed in the first sub-pixel circuit area PCA1 with the valley VY therebetween. In other words, the auxiliary transistor AT may be disposed at an opposite side to the second transistor T2 with a valley VY defined in the at least one inorganic insulating layer therebetween. The opposite side may be defined in relation to the valley VY.

One end of the auxiliary semiconductor layer AA disposed in the second sub-pixel circuit area PCA2 may be electrically connected to the data line DL disposed in the first sub-pixel circuit area PCA1 through the first connection line CL1, and the other end of the auxiliary semiconductor layer AA disposed in the second sub-pixel circuit area PCA2 may be electrically connected to the first semiconductor layer A1 disposed in the first sub-pixel circuit area PCA1 through the second connection line CL2. One end of the first connection line CL1 may be connected to one end of the auxiliary semiconductor layer AA through the thirteenth connection electrode NM13, and the other end of the first connection line CL1 may be connected to the data line DL. One end of the second connection line CL2 may be connected to one end of the auxiliary semiconductor layer AA through the twelfth connection electrode NM12, and the other end of the second connection line CL2 may be electrically connected to the first semiconductor layer A1 through the fourteenth connection electrode NM14.

A data signal of the data line DL passing through the first sub-pixel circuit area PCA1 may be transmitted to the auxiliary semiconductor layer AA positioned in the second sub-pixel circuit area PCA2 through the first connection line CL1 extending in the x-direction to cross the valley VY.

As described above with reference to FIGS. 12 and 13, the first scan line (SL1 of FIG. 13) may be electrically connected to the first auxiliary scan line SL1a each including the second gate electrode G2 and the auxiliary gate electrode AG. The first auxiliary scan line SL1a may be also called as a second auxiliary scan line. Thus, a first scan signal of the first scan line (SL1 of FIG. 13) may be transmitted to each of the second gate electrode G2 and the auxiliary gate electrode AG. In other words, the same first scan signal may be applied to the second gate electrode G2 and the auxiliary gate electrode AG.

Referring to a first path P1 of FIG. 15, the second transistor T2 may be turned on in response to a first scan signal transmitted through the first scan line (SL1 of FIG. 13) and may transmit the data signal transmitted to the data line DL to the first semiconductor layer A1 of the first transistor T1.

The auxiliary transistor AT may also perform the same operation as the second transistor T2. Referring to a second path P2 of FIG. 15, the auxiliary transistor AT may be turned on in response to the first scan signal transmitted through the first scan line (SL1 of FIG. 13), and the data signal of the data line DL may be transmitted to the first semiconductor layer A1 through the first connection line CL1, the auxiliary semiconductor layer AA, and the second connection line CL2.

When a normal operation of the second transistor T2 is difficult due to an impact that may occur when an object such as a stylus pen drops to the display area (that is, when an normal connection of the first path P1 is abnormal), the auxiliary transistor AT may form a bypass path. In other words, when the first path P1 is abnormal, the data signal may be written to the first transistor T1 through the second path P2 using the auxiliary transistor AT.

As a comparative example of the present invention, when the auxiliary transistor AT is not present, or when the normal operation of the second transistor T2 is difficult, a weak point may be expressed. However, according to embodiments of the present invention, the data signal may be written to the first transistor T1 through the second path P2 using the auxiliary transistor AT so that the above-described problem may be prevented from occurring.

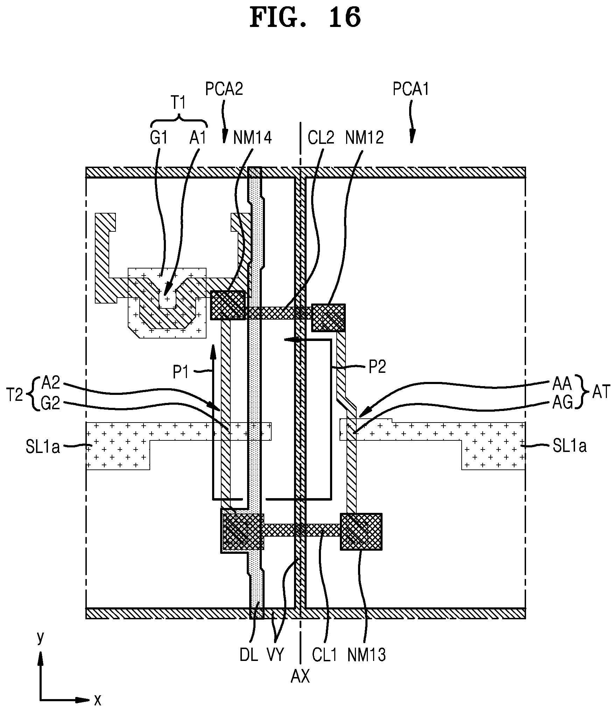

FIG. 16 is an extracted plan view illustrating a portion of a first transistor and a second transistor arranged in a second sub-pixel circuit area of the display device shown in FIG. 14 and an auxiliary transistor arranged in a first sub-pixel circuit area of the display device of FIG. 14.

The first transistor T1 disposed in the second sub-pixel circuit area PCA2 may be electrically connected to the second transistor T2 and the auxiliary transistor AT disposed in the first sub-pixel circuit area PCA1. The first transistor T1 may include a first semiconductor layer A1 and a first gate electrode G1, and the second transistor T2 may include a second semiconductor layer A2 and a second gate electrode G2. The first semiconductor layer A1 of the first transistor T1 may be integral with the second semiconductor layer A2 of the second transistor T2.

The auxiliary transistor AT may include an auxiliary semiconductor layer AA and an auxiliary gate electrode AG disposed in the first sub-pixel circuit area PCA1. The auxiliary semiconductor layer AA of the auxiliary transistor AT may be spaced apart from the first semiconductor layer A1 of the first transistor T1 and the second semiconductor layer A2 of the second transistor T2 disposed in the second sub-pixel circuit area PCA2 with the valley VY therebetween.

One end of the auxiliary semiconductor layer AA disposed in the first sub-pixel circuit area PCA1 may be electrically connected to the data line DL disposed in the second sub-pixel circuit area PCA2 through the first connection line CL1, and the other end of the auxiliary semiconductor layer AA disposed in the first sub-pixel circuit area PCA1 may be electrically connected to the first semiconductor layer A1 disposed in the second sub-pixel circuit area PCA2 through the second connection line CL2. One end of the first connection line CL1 may be connected to one end of the auxiliary semiconductor layer AA through the thirteenth connection electrode NM13, and the other end of the first connection line CL1 may be connected to the data line DL. One end of the second connection line CL2 may be connected to one end of the auxiliary semiconductor layer AA through the twelfth connection electrode NM12, and the other end of the second connection line CL2 may be electrically connected to the first semiconductor layer A1 through the fourteenth connection electrode NM14.

A data signal of the data line DL passing through the second sub-pixel circuit area PCA2 may be transmitted to the auxiliary semiconductor layer AA positioned in the first sub-pixel circuit area PCA1 through the first connection line CL1 extending in the x-direction to cross the valley VY.

As described above with reference to FIGS. 12 and 13, the first scan line (SL1 of FIG. 13) may be electrically connected to the first auxiliary scan line SL1a each including the second gate electrode G2 and the auxiliary gate electrode AG. Thus, a first scan signal of the first scan line (SL1 of FIG. 13) may be transmitted to each of the second gate electrode G2 and the auxiliary gate electrode AG. In other words, the same first scan signal may be applied to the second gate electrode G2 and the auxiliary gate electrode AG.

Referring to a first path P1 of FIG. 16, the second transistor T2 may be turned on in response to a first scan signal transmitted through the first scan line (SL1 of FIG. 13) and may transmit the data signal transmitted to the data line DL to the first semiconductor layer A1 of the first transistor T1.

The auxiliary transistor AT may also perform the same operation as the second transistor T2. Referring to a second path P2 of FIG. 16, the auxiliary transistor AT may be turned on in response to the first scan signal transmitted through the first scan line (SL1 of FIG. 13), and the data signal of the data line DL may be transmitted to the first semiconductor layer A1 through the first connection line CL1, the auxiliary semiconductor layer AA, and the second connection line CL2.

When a normal operation of the second transistor T2 is difficult due to an impact that may occur when an object such as a stylus pen drops to the display area (that is, when an normal connection of the first path P1 is abnormal), the auxiliary transistor AT may form a bypass path. In other words, when the first path P1 is abnormal, the data signal may be written to the first transistor T1 through the second path P2 using the auxiliary transistor AT. Because the data signal may be written to the first transistor T1 through the second path P2 using the auxiliary transistor AT, the above-described problem may be prevented from occurring.

According to an embodiment of the present invention, generation of fine cracks may be minimized by minimizing display strain due to external impact, and propagation to surroundings may be minimized even if fine cracks occur. In addition, even if a fine crack occurs due to an external impact, a high-quality image can be provided by using the auxiliary transistor. Of course, the scope of the present invention is not limited by these effects.

## Claims

1. A display device (10) comprising:
a substrate (100);
a scan line (SL) disposed on the substrate (100) and extending in a first direction;
a data line (DL) disposed on the substrate (100) and extending in a second direction crossing the first direction;
a first transistor (T1) disposed on the substrate (100) and comprising a first semiconductor layer (A1) and a first gate electrode (G1) overlapping the first semiconductor layer (A1);
a second transistor (T2) comprising a second semiconductor layer (A2) electrically connected to the first transistor (T1) and the data line (DL), and a second gate electrode (G2) overlapping the second semiconductor layer (A2) and electrically connected to the scan line (SL);
at least one inorganic insulating layer disposed on the substrate (100); and
an auxiliary transistor (AT) disposed at an opposite side to the second transistor (T2) with a valley (VY) defined in the at least one inorganic insulating layer therebetween,
wherein the auxiliary transistor (AT) is electrically connected to the data line (DL) and the scan line (SL)
a first auxiliary scan line (SL1a) comprising the second gate electrode (G2); and
a second auxiliary scan line comprising the auxiliary gate electrode (AG), wherein each of the first auxiliary scan line (SL1a) and the second auxiliary scan line is electrically connected to the scan line (SL), wherein the first auxiliary scan line (SL1a) and the second auxiliary scan line are spaced apart from each other with the valley (VY) therebetween.

2. The display device (10) of claim 1, further comprising:
a first sub-pixel circuit area (PCA1) and a second sub-pixel circuit area (PCA2) arranged adjacent to each other,
wherein the scan line (SL) passing through the first sub-pixel circuit area (PCA1) and the second sub-pixel circuit area (PCA2),
and the data line (DL) passing through the first sub-pixel circuit area (PCA1),
wherein the second semiconductor layer (A2) is disposed in the first sub-pixel circuit area (PCA1),
wherein the valley (VY) is disposed between the first sub-pixel circuit area (PCA1) and the second sub-pixel circuit area (PCA2), and
the auxiliary transistor (AT) comprises an auxiliary semiconductor layer (AA) disposed in the second sub-pixel circuit area (PCA2) and an auxiliary gate electrode (AG) overlapping the auxiliary semiconductor layer (AA).

3. The display device (10) of claim 1, wherein the auxiliary transistor (AT) comprises an auxiliary semiconductor layer (AA) disposed at an opposite side to the second semiconductor layer (A2) with the valley (VY) therebetween and an auxiliary gate electrode (AG) electrically connected to the scan line (SL) and overlapping the auxiliary semiconductor layer (AA).

4. The display device (10) of claim 2 or 3, further comprising:
a first connection line (CL1) configured to electrically connect the data line (DL) and the auxiliary semiconductor layer (AA) to each other, the first connection line (CL1) overlapping the valley (VY); and
a second connection line (CL2) configured to electrically connect the auxiliary semiconductor layer (AA) and the first semiconductor layer (A1) to each other, the second connection line (CL2) overlapping the valley (VY).

5. The display device (10) of claim 4, wherein the first connection line (CL1) and the second connection line (CL2) comprise a same material.

6. The display device (10) of claim 4, wherein the first connection line (CL1) and the second connection line (CL2) comprise a same material as the scan line (SL).

7. The display device (10) of at least of one of claims 2 to 6, wherein the auxiliary semiconductor layer (AA) comprises a same material as the second semiconductor layer (A2).

8. The display device (10) of at least one of claims 1 to 7, further comprising an organic insulating material at least partially filling the valley (VY).

9. The display device (10) of claim 2 or at least one of claims 5 to 8, further comprising:
a first connection line (CL1) disposed on the organic insulating material and configured to electrically connect the data line (DL) and the auxiliary semiconductor layer (AA) to each other, the first connection line (CL1) overlapping the valley (VY); and
a second connection line (CL2) disposed on the organic insulating material and configured to electrically connect the auxiliary semiconductor layer (AA) and the first semiconductor layer (A1) to each other, the second connection line (CL2) overlapping the valley (VY).

10. The display device (10) of claim 2 or claim 2 and at least one of claims 4 to 9, further comprising a third transistor (T3) disposed in the first sub-pixel circuit area (PCA1) and electrically connected to the first transistor (T1).

11. The display device (10) of claim 10, wherein the third transistor (T3) comprises a third semiconductor layer (A3) comprising a different material from the first semiconductor layer and a third gate electrode (G3) overlapping the third semiconductor layer (A3).

12. The display device (10) of claim 11, wherein the first semiconductor layer (A1) and the third semiconductor layer (A3) are arranged on different layers.

## Patentansprüche

1. Eine Anzeigevorrichtung (10), umfassend:
ein Substrat (100);
eine Scanleitung (SL), angeordnet auf dem Substrat (100) und sich erstreckend in einer ersten Richtung;
eine Datenleitung (DL), angeordnet auf dem Substrat (100) und sich erstreckend in einer zweiten Richtung, die die erste Richtung kreuzt;
einen ersten Transistor (T1), angeordnet auf dem Substrat (100) und umfassend eine erste Halbleiterschicht (A1) und eine erste Gateelektrode (G1), die die erste Halbleiterschicht (A1) überlappt;
einen zweiten Transistor (T2), umfassend eine zweite Halbleiterschicht (A2), die elektrisch verbunden ist mit dem ersten Transistor (T1) und der Datenleitung (DL),
und eine zweite Gateelektrode (G2), die die zweite Halbleiterschicht (A2) überlappt und elektrisch mit der Scanleitung (SL) verbunden ist;
mindestens eine anorganische Isolierschicht, angeordnet auf dem Substrat (100); und
einen Hilfstransistor (AT), angeordnet auf einer gegenüberliegenden Seite zu dem zweiten Transistor (T2), mit einem Tal (VY), das in der mindestens einen anorganischen Isolierschicht dazwischen definiert ist,
wobei der Hilfstransistor (AT) elektrisch verbunden ist mit der Datenleitung (DL) und der Scanleitung (SL),
eine erste Hilfsscanleitung (SL1a), umfassend die zweite Gateelektrode (G2); und
eine zweite Hilfsscanleitung, umfassend die Hilfsgateelektrode (AG),
wobei jede von der ersten Hilfsscanleitung (SL1a) und der zweiten Hilfsscanleitung elektrisch mit der Scanleitung (SL) verbunden ist, und wobei die erste Hilfsscanleitung (SL1a) und die zweite Hilfsscanleitung voneinander mit dem Tal (VY) dazwischen beabstandet sind.

2. Die Anzeigevorrichtung (10) nach Anspruch 1, ferner umfassend:
einen ersten Subpixel-Schaltungsbereich (PCA1) und einen zweiten Subpixel-Schaltungsbereich (PCA2), die benachbart zueinander angeordnet sind,
wobei die Scanleitung (SL) durch den ersten Subpixel-Schaltungsbereich (PCA1) und den zweiten Subpixel-Schaltungsbereich (PCA2) verläuft,
und die Datenleitung (DL) durch den ersten Subpixel-Schaltungsbereich (PCA1) verläuft,
wobei die zweite Halbleiterschicht (A2) in dem ersten Subpixel-Schaltungsbereich (PCA1) angeordnet ist,
wobei das Tal (VY) zwischen dem ersten Subpixel-Schaltungsbereich (PCA1) und dem zweiten Subpixel-Schaltungsbereich (PCA2) angeordnet ist, und
der Hilfstransistor (AT) eine Hilfshalbleiterschicht (AA), angeordnet in dem zweiten Subpixel-Schaltungsbereich (PCA2), und eine Hilfsgateelektrode (AG), die die Hilfshalbleiterschicht (AA) überlappt, umfasst.

3. Die Anzeigevorrichtung (10) nach Anspruch 1, wobei der Hilfstransistor (AT) eine Hilfshalbleiterschicht (AA) umfasst, die auf einer gegenüberliegenden Seite zu der zweiten Halbleiterschicht (A2) mit dem Tal (VY) dazwischen angeordnet ist, und eine Hilfsgateelektrode (AG), die elektrisch mit der Scanleitung (SL) verbunden ist und die Hilfshalbleiterschicht (AA) überlappt.

4. Die Anzeigevorrichtung (10) nach Anspruch 2 oder 3, ferner umfassend:
eine erste Verbindungsleitung (CL1), konfiguriert, um die Datenleitung (DL) und die Hilfshalbleiterschicht (AA) elektrisch miteinander zu verbinden, wobei die erste Verbindungsleitung (CL1) das Tal (VY) überlappt; und
eine zweite Verbindungsleitung (CL2), konfiguriert, um die Hilfshalbleiterschicht (AA) und die erste Halbleiterschicht (A1) elektrisch miteinander zu verbinden, wobei die zweite Verbindungsleitung (CL2) das Tal (VY) überlappt.

5. Die Anzeigevorrichtung (10) nach Anspruch 4, wobei die erste Verbindungsleitung (CL1) und die zweite Verbindungsleitung (CL2) ein selbes Material umfassen.

6. Die Anzeigevorrichtung (10) nach Anspruch 4, wobei die erste Verbindungsleitung (CL1) und die zweite Verbindungsleitung (CL2) ein selbes Material wie die Scanleitung (SL) umfassen.

7. Die Anzeigevorrichtung (10) nach mindestens einem der Ansprüche 2 bis 6, wobei die Hilfshalbleiterschicht (AA) ein selbes Material wie die zweite Halbleiterschicht (A2) umfasst.

8. Die Anzeigevorrichtung (10) nach mindestens einem der Ansprüche 1 bis 7, ferner umfassend ein organisches Isoliermaterial, das das Tal (VY) zumindest teilweise füllt.

9. Die Anzeigevorrichtung (10) nach Anspruch 2 oder mindestens einem der Ansprüche 5 bis 8, ferner umfassend:
eine erste Verbindungsleitung (CL1), angeordnet auf dem organischen Isoliermaterial und konfiguriert, um die Datenleitung (DL) und die Hilfshalbleiterschicht (AA) elektrisch miteinander zu verbinden, wobei die erste Verbindungsleitung (CL1) das Tal (VY) überlappt; und
eine zweite Verbindungsleitung (CL2), angeordnet auf dem organischen Isoliermaterial und konfiguriert, um die Hilfshalbleiterschicht (AA) und die erste Halbleiterschicht (A1) elektrisch miteinander zu verbinden, wobei die zweite Verbindungsleitung (CL2) das Tal (VY) überlappt.

10. Die Anzeigevorrichtung (10) nach Anspruch 2 oder Anspruch 2 und mindestens einem der Ansprüche 4 bis 9, ferner umfassend einen dritten Transistor (T3), angeordnet in dem ersten Subpixel-Schaltungsbereich (PCA1) und elektrisch verbunden mit dem ersten Transistor (T1).

11. Die Anzeigevorrichtung (10) nach Anspruch 10, wobei der dritte Transistor (T3) eine dritte Halbleiterschicht (A3) umfasst, die ein anderes Material als die erste Halbleiterschicht umfasst, und eine dritte Gateelektrode (G3), die die dritte Halbleiterschicht (A3) überlappt.

12. Die Anzeigevorrichtung (10) nach Anspruch 11, wobei die erste Halbleiterschicht (A1) und die dritte Halbleiterschicht (A3) auf unterschiedlichen Schichten angeordnet sind.

## Revendications

1. Dispositif d'affichage (10) comprenant :
un substrat (100) ;
une ligne de balayage (SL) disposée sur le substrat (100) et s'étendant dans une première direction ;
une ligne de données (DL) disposée sur le substrat (100) et s'étendant dans une deuxième direction intersectant la première direction ;
un premier transistor (T1) disposé sur le substrat (100) et comprenant une première couche semi-conductrice (A1) et une première électrode de grille (G1) chevauchant la première couche semi-conductrice (A1) ;
un deuxième transistor (T2) comprenant une deuxième couche semi-conductrice (A2) connectée électriquement au premier transistor (T1) et à la ligne de données (DL), et une deuxième électrode de grille (G2) chevauchant la deuxième couche semi-conductrice (A2) et connectée électriquement à la ligne de balayage (SL) ;
au moins une couche isolante inorganique disposée sur le substrat (100) ; et
un transistor auxiliaire (AT) disposé sur un côté opposé au deuxième transistor (T2) avec un creux (VY) défini dans l'au moins une couche isolante inorganique entre les deux,
dans lequel le transistor auxiliaire (AT) est connecté électriquement à la ligne de données (DL) et à la ligne de balayage (SL),
une première ligne de balayage auxiliaire (SL1a) comprenant la deuxième électrode de grille (G2) ; et
une deuxième ligne de balayage auxiliaire comprenant l'électrode de grille auxiliaire (AG),
dans lequel chacune de la première ligne de balayage auxiliaire (SL1a) et de la deuxième ligne de balayage auxiliaire est connectée électriquement à la ligne de balayage (SL), dans lequel la première ligne de balayage auxiliaire (SL1a) et la deuxième ligne de balayage auxiliaire sont espacées l'une de l'autre avec le creux (VY) entre les deux.

2. Dispositif d'affichage (10) selon la revendication 1, comprenant en outre :
une première zone de circuit de sous-pixels (PCA1) et une deuxième zone de circuit de sous-pixels (PCA2) disposées adjacentes l'une à l'autre,
dans lequel une ligne de balayage (SL) traversant la première zone de circuit de sous-pixels (PCA1) et la deuxième zone de circuit de sous-pixels (PCA2),
et la ligne de données (DL) traversant la première zone de circuit de sous-pixels (PCA1),
dans lequel la deuxième couche semi-conductrice (A2) est disposée dans la première zone de circuit de sous-pixels (PCA1),
dans lequel le creux (VY) est ménagé entre la première zone de circuit de sous-pixels (PCA1) et la deuxième zone de circuit de sous-pixels (PCA2), et
un transistor auxiliaire (AT) comprend une couche semi-conductrice auxiliaire (AA) disposée dans la deuxième zone de circuit de sous-pixels (PCA2) et une électrode de grille auxiliaire (AG) chevauchant la couche semi-conductrice auxiliaire (AA).

3. Dispositif d'affichage (10) selon la revendication 1, dans lequel le transistor auxiliaire (AT) comprend une couche semi-conductrice auxiliaire (AA) disposée sur un côté opposé à la deuxième couche semi-conductrice (A2) avec le creux (VY) entre les deux et une électrode de grille auxiliaire (AG) connectée électriquement à la ligne de balayage (SL) et chevauchant la couche semi-conductrice auxiliaire (AA).

4. Dispositif d'affichage (10) selon la revendication 2 ou 3, comprenant en outre :
une première ligne de connexion (CL1) configurée pour connecter électriquement la ligne de données (DL) et la couche semi-conductrice auxiliaire (AA) l'une à l'autre, la première ligne de connexion (CL1) chevauchant le creux (VY) ; et
une deuxième ligne de connexion (CL2) configurée pour connecter électriquement la couche semi-conductrice auxiliaire (AA) et la première couche semi-conductrice (A1) l'une à l'autre, la deuxième ligne de connexion (CL2) chevauchant le creux (VY).

5. Dispositif d'affichage (10) selon la revendication 4, dans lequel la première ligne de connexion (CL1) et la deuxième ligne de connexion (CL2) comprennent le même matériau.

6. Dispositif d'affichage (10) selon la revendication 4, dans lequel la première ligne de connexion (CL1) et la deuxième ligne de connexion (CL2) comprennent le même matériau que la ligne de balayage (SL).

7. Dispositif d'affichage (10) selon au moins l'une des revendications 2 à 6, dans lequel la couche semi-conductrice auxiliaire (AA) comprend le même matériau que la deuxième couche semi-conductrice (A2).

8. Dispositif d'affichage (10) selon au moins l'une des revendications 1 à 7, comprenant en outre un matériau isolant organique remplissant au moins partiellement le creux (VY).

9. Dispositif d'affichage (10) selon la revendication 2 ou au moins l'une des revendications 5 à 8, comprenant en outre :
une première ligne de connexion (CL1) disposée sur le matériau isolant organique et configurée pour connecter électriquement la ligne de données (DL) et la couche semi-conductrice auxiliaire (AA) l'une à l'autre, la première ligne de connexion (CL1) chevauchant le creux (VY) ; et
une deuxième ligne de connexion (CL2) disposée sur le matériau isolant organique et configurée pour connecter électriquement la couche semi-conductrice auxiliaire (AA) et la première couche semi-conductrice (A1) l'une à l'autre, la deuxième ligne de connexion (CL2) chevauchant le creux (VY).

10. Dispositif d'affichage (10) selon la revendication 2 ou la revendication 2 et au moins l'une des revendications 4 à 9, comprenant en outre un troisième transistor (T3) disposé dans la première zone de circuit de sous-pixels (PCA1) et connecté électriquement au premier transistor (T1).

11. Dispositif d'affichage (10) selon la revendication 10, dans lequel le troisième transistor (T3) comprend une troisième couche semi-conductrice (A3) comprenant un matériau différent de la première couche semi-conductrice et une troisième électrode de grille (G3) chevauchant la troisième couche semi-conductrice (A3).

12. Dispositif d'affichage (10) selon la revendication 11, dans lequel la première couche semi-conductrice (A1) et la troisième couche semi-conductrice (A3) sont disposées sur des couches différentes.
